# EUROPEAN PATENT APPLICATION

(11) **EP 4 687 006 A1**
(43) Date of publication of application: **04.02.2026**
(21) Application number: 25173338.2
(22) Date of filing: 29.04.2025
(51) Int. Cl.: G06F 1/20, H05K 7/20

(54) **DYNAMIC POSITION ADJUSTMENT OF COOLING COMPONENTS IN A COMPUTING APPARATUS FOR ENHACED COOLING EFFICIENCY**

(30) Priority: 30.07.2024 US 202418788646
(71) Applicant: Intel Corporation, Santa Clara, CA 95054 (US)
(72) Inventor: BERNAT, Francesc Guim, 08036 Barcelona (ES); KUMAR, Karthik, Chandler, 85249 (US); CARRANZA, Marcos, Portland, 97229 (US); QURESHI, Uzair, Chandler, 85249 (US); PIOTROWSKI, Marek, 83330 Pepowo, Pomorskie (PL)
(74) Representative: Maiwald GmbH

(57) **Abstract**

Software defined cooling structures are described. A method comprises decoding sensor data from a sensor of an electronic component of an electronic device, generating a control directive to move a software defined cooling (SDC) structure of a cooling system from a first position to a second position based on the sensor data, moving the SDC structure from the first position to the second position in response to the control directive, the second position to comprise a position within a defined distance to the electronic component of the electronic device, and performing thermal management of the electronic component using the SDC structure. Other embodiments are described and claimed.

## Description

### BACKGROUND

The increased growth and sophistication of artificial intelligence (AI) have driven design of larger and more powerful processors to manage the demands of large-scale language training programs required by AI developers. For example, semiconductor chips may contain billions of transistors (e.g., fin field-effect (FinFET) transistors) with decreasing die sizes that can execute tera floating point operations per second (TFLOP) of performance. With the increased demand for AI and the vast amounts of data needed to build AI services coupled with the increasing volume of data generated by other sources, such as edge computing and sixth generation (6G) cellular networks, the need for sustainable and scalable compute and storage solutions is becoming more urgent. However, an increase in data center capacity to fill this need is also resulting in an increase in energy consumption. This increase in data center energy demand is testing the limits of legacy thermal technologies. Effectively and efficiently cooling these chips presents new thermal challenges for legacy cooling technologies.

### BRIEF DESCRIPTION OF THE SEVERAL VIEWS OF THE DRAWINGS

To easily identify the discussion of any particular element or act, the most significant digit or digits in a reference number refer to the figure number in which that element is first introduced.
FIG. 1 illustrates a cooling system in accordance with one embodiment.
FIG. 2A illustrates a cooling system in accordance with one embodiment.
FIG. 2B illustrates a cooling system in accordance with one embodiment.
FIG. 3 illustrates an apparatus in accordance with one embodiment.
FIG. 4 illustrates a logic diagram in accordance with one embodiment.
FIG. 5 illustrates a logic diagram in accordance with one embodiment.
FIG. 6 illustrates a logic diagram in accordance with one embodiment.
FIG. 7 illustrates a logic diagram in accordance with one embodiment.
FIG. 8 illustrates a logic diagram in accordance with one embodiment.
FIG. 9 illustrates a logic diagram in accordance with one embodiment.
FIG. 10 illustrates a logic diagram in accordance with one embodiment.
FIG. 11 illustrates a logic diagram in accordance with one embodiment.
FIG. 12 illustrates a system in accordance with one embodiment.
FIG. 13 illustrates an apparatus in accordance with one embodiment.
FIG. 14 illustrates a logic flow in accordance with one embodiment.
FIG. 15 illustrates a computer-readable storage medium in accordance with one embodiment.
FIG. 16 illustrates a computing architecture in accordance with one embodiment.
FIG. 17 illustrates a communications architecture in accordance with one embodiment.

### DETAILED DESCRIPTION

Embodiments generally relate to cooling techniques for thermal management of electronic devices such as semiconductor devices. Embodiments particularly relate to an adaptive computing and cooling architecture for electronic devices for implementation in larger electronic devices, platforms or systems, such as server blades for a server rack of a data center to provide computing and storage services.

Data centers are complex systems in which multiple technologies and pieces of hardware interact to maintain safe and continuous operation of servers. With so many systems requiring power, the electrical energy used generates thermal energy. As the center operates, this heat builds and, unless removed, can cause equipment failures, system shutdowns, and physical damage to components. Much of this increased heat can be attributed to different processing units, collectively referred to as an "XPU," where X stands for different letters depending on the context or specific function of the processing unit, which represents a shift towards more specialized, task-specific processors. Examples of an XPU include a central processing unit (CPU), graphics processing unit (GPU), data processing unit (DPU), vision processing unit (VPU), neural processing unit (NPU), infrastructure processing unit (IPU), tensor processing unit (TPU), and other processing units. Each new generation of XPU processor seems to offer greater speed, functionality, and storage, and chips are being asked to carry more of the load.

An increasingly urgent challenge is to find a new approach to cooling data centers that reaches beyond legacy thermal technologies, that is both energy-efficient and scalable, with the ultimate goal of enabling greater compute and data storage in an energy-efficient context. Effective operation of any processor depends on temperatures remaining within designated thresholds. The more power an XPU uses, the hotter it becomes. When a component approaches its maximum temperature, a device may attempt to cool the processor by lowering its frequency or throttling it. While effective in the short term, repeated throttling can have negative effects, such as shortening the life of the component.

A potential thermal management approach for cooling data centers is referred to as liquid cooling. Examples of liquid cooling techniques include direct liquid cooling, also known as direct-to-chip (DTC) cooling, and liquid immersion cooling. DTC cooling manages heat through the direct application of a coolant liquid onto the heat-generating components, such as processors and memory units. Unlike traditional air cooling that uses fans to circulate air around these components, direct liquid cooling involves circulating a coolant through a closed loop that absorbs heat directly from the components. This process significantly enhances cooling efficiency because liquids generally have higher heat capacity and conductivity than air. In direct liquid cooling systems, the coolant is pumped through cold plates that are in direct or indirect contact with the components. The heat from the components is transferred to the coolant. It is then circulated away and cooled through a heat exchanger. This method allows for more effective heat dissipation, enabling higher performance, increased component density, and potentially quieter operation due to the reduced need for fans. Direct liquid cooling is particularly beneficial in high-performance computing environments, like data centers and servers, as well as in high-end gaming personal computers and workstations, where the heat generated can exceed the capabilities of traditional air cooling methods.

In liquid immersion cooling systems, an immersion tank is filled with a dielectric fluid that partially or fully covers electronic components. The fluid dissipates heat generated by the electronic components. In open bath systems, an immersion tank is covered or uncovered and operates at atmospheric pressure. In closed bath systems, an immersion tank seals off the immersion fluid from the environment. The electronic components are fully submerged in a thermally conductive, electrically non-conductive liquid within a sealed enclosure. The closed bath immersion tank prevents the cooling liquid from coming into contact with the external environment. This enclosure helps in maintaining the integrity and cleanliness of the liquid, preventing contamination and evaporation.

Architecting cooling solutions for emerging systems comes with several challenges. As compute demand has grown significantly, particularly with generative AI usage driving very heavy workloads for compute and memory subsystems, so has the power consumption and associated thermals for the platform. Currently, a lot of effort and innovation goes into cooling solutions that are designed for the platform. However, these solutions are pre-established with static configurations that are not changed after deployment. For example, an immersion cooling system architecture is typically designed upfront for a given electronic device or electronic system, and the cooling elements are statically placed.

While the obvious advantage of an a priori cooling system design is simplicity, and uniformity, there are several challenges emerging with such a solution in emerging data centers. For example, systems have different and varying requirements depending on usage, deployment location, environmental conditions, and so forth. Designing the entire cooling solution statically upfront for a worst case scenario is severely limiting and often constrains the system in terms of power, far beyond what might be possible at a component level. This in turn can hurt performance and capability, due to different components being stressed differently depending on the workload. Further, current systems are increasingly configurable with varying XPUs. As requirements change and usage patterns change, system configurations can also change. For example, a system can add an accelerator or swap out memory units. However, when the cooling solution is designed a priori to be static, changing the configuration can be extremely limiting and require iteration to a factory process. This can be prohibitively expensive, inefficient, or limit performance.

Conventional cooling solutions face other technical challenges as well. As compute demands continue to grow, especially with the increasing prevalence of accelerators and GPUs for generative AI solutions, thermal constraints emerge as a significant bottleneck for system and server rack design. This in turn, has placed a sharp emphasis on cooling solutions to manage this power consumption. In current data centers, all the cooling systems act as independent entities that operate cooling mechanisms to maintain a certain temperature target. However, workloads and use cases do not always require a constant energy efficiency or performance. Therefore, cooling requirements for a system will change over time, depending on factors such as the phases of the workload, overall load on the system, priority levels, or service level objectives (SLO). Further, system resources consumed by the varying workloads may also change over time. For example, machine learning (ML) models such as large language models (LLMs) operate in two phases. The first phase is a time to first token. The second phase is an average time for a remainder of the tokens. Unlike the first phase, the second phase is completely memory bandwidth bound, and exercises significant power (and thermal stress) on the memory subsystem. However, this phenomena is not observed in the first phase. Conventional cooling solutions implement static cooling solutions that cannot adapt to different operational phases of software and hardware.

Various embodiments are generally directed to software defined cooling (SDC) structures for a cooling system of an electronic device, such as a server blade in a server rack for a data center, for example. A software application may dynamically change a topology for the SDC structures to distribute cooling provided by the cooling system in response to changes in operating conditions for the electronic device. The SDC structures are movable cooling components arranged for movement internal to a chassis of an electronic device. The SDC structures are attached to a motion control system allowing for automated or controlled movement of the SDC structures to change how the SDC structures are spatially positioned in different cooling zones within a device chassis of the electronic device. Further, the software application can automatically program locations for the SDC structures within the device chassis to ensure proper cooling of electronic components within the device chassis in accordance with various cooling policies, such as service level objectives (SLOs) defined by service level agreements (SLAs) associated with the electronic components and/or the cooling zones.

Some embodiments are particularly directed to precision delivery of cooling and power resources across different parts of an electronic device. In one embodiment, for example, an electronic device is divided into one or more cooling zones. A cooling zone is a defined spatial area within a device chassis. The defined spatial area may be a two-dimensional (2D) area or a three-dimensional (3D) area within the device chassis. Each cooling zone includes one or more electronic components. For example, a first cooling zone includes a power supply, a second cooling zone includes semiconductor devices mounted on a printed circuit board (PCB), a third cooling zone includes a storage device, a fourth cooling zone includes a network interface card (NIC), and so forth. Each cooling zone includes one or more sensors. One or more SDC structures are mounted on a motion control system or mechanical actuator, such as a cooling rail track, for example. System control circuitry (e.g., a controller) moves the SDC structures to the different cooling zones to deliver precision cooling to the electronic components within the different cooling zones based on sensor data, instantaneous workloads of the electronic components, or predicted workloads for the electronic components. For example, the system control circuitry increases or decreases distribution of system resources, such as an amount of cooling or power from a cooling budget or a power budget, in response to changes in current workloads of the electronic components, future workloads of the electronic components, updated cooling zones, updated configuration data for cooling zones, availability of system resources, co-orchestration with other electronic devices (e.g., in a server farm), and other component-level or system-level parameters.

In one embodiment, for example, a computing apparatus includes a memory operably coupled to circuitry. The circuitry performs operations, such as cooling operations to decode sensor data from a sensor of an electronic component of an electronic device, generate a control directive to move a SDC structure of a cooling system from a first position to a second position based on the sensor data, move the SDC structure from the first position to the second position in response to the control directive, where the second position to comprise a position within a defined distance to the electronic component of the electronic device, and perform thermal management of the electronic component using the SDC structure. For example, the first position and the second position represent numerical coordinates in a 3D coordinate system, such as a Cartesian coordinate system. For example, the first position is located in a first cooling zone and the second position is located in a second cooling zone.

In one embodiment, for example, the circuitry is arranged to access configuration data for a cooling zone where the electronic component is located, where the configuration data includes a volumetric area for the cooling zone, an SLA or an SLO defining an operating target for the cooling zone, a priority level associated with the cooling zone, or reservation data for the cooling zone.

In one embodiment, for example, the circuitry is arranged to decode sensor data from a sensor that the SDC structure is located at the second position, and generate a control directive to initiate cooling operations of the SDC structure to reduce a temperature of the electronic component by the SDC structure. For example, the circuitry is arranged to generate the control directive to move the SDC structure of the cooling system from the first position to the second position based on the sensor data and the volumetric area for the cooling zone, the SLA or SLO for the cooling zone, the priority level associated with the cooling zone, or the reservation data for the cooling zone.

Various embodiments utilize a machine learning (ML) algorithm to train a ML model to predict workloads for the electronic components, configure or re-configure the cooling zones, generate cooling and/or power requirements for the cooling zones, and perform other downstream tasks. In one embodiment, for example, the circuitry is arranged to receive as input the configuration data for the cooling zone by a machine learning model for a first defined time interval, and generate an amount of cooling the SDC structure delivers for the cooling zone within the first defined time interval by the machine learning model based on the configuration data. In one embodiment, for example, the circuitry is arranged to receive as input the reservation data for the cooling zone by a machine learning model for a first defined time interval and a second defined time interval, generate an amount of cooling the SDC structure delivers for the cooling zone within the first defined time interval and the second defined time interval by the machine learning model based on the reservation data.

The embodiments provide several technical advantages relative to conventional cooling systems. For example, conventional cooling solutions are typically pre-established with a static configuration that can never be changed. Therefore, an original equipment manufacturer (OEM) must design and configure a conventional cooling solution for a system prior to deployment. Embodiments implement SDC structures that can be configured by software. For example, software application programming interfaces (APIs) are used to define cooling topologies in an electronic device or electronic system, similar to how software defined networks provide flexibility in system network design. A system logs telemetry data with the help of a set of smart temperature sensors. These sensors in turn are queryable and exposed to system administrators via APIs, in addition to being used by the system itself to understand current thermal profiles, cooling adequacy, and cooling capacity for deployed cooling solutions. This gives the system visibility into how much cooling capacity is available across a spatial profile in a given server. Further, the system dynamically adapts the cooling capability in response to thermal needs of a system or sub-system. For example, the system could have mechanical structures to reposition fans, or adapt a direction and flow of a cooling liquid or condenser coils, without having to go back to the factory for a redesign. In addition, embodiments recognize that workload resource requirements change over time, and learn to recognize changes in execution phases and communicate these phase changes to a centralized cooling infrastructure. Embodiments perform precision cooling that is co-orchestrated with software and hardware system requirements. Embodiments implement a set of APIS to adapt cooling per cooling zones depending on SLOs and SLAs. Embodiments adaptively distribute, control, and deliver power and cooling across different parts of a system or subsystem. Embodiments use a network of sensors to monitor a set of metrics associated with electronic components, such as XPU metrics like floating point operations (FLOPS) or clocks per instruction. Embodiments use this information to implement a closed loop power and liquid cooling intelligent infrastructure. For example, embodiments may implement a definition such as X FLOPS at Y Watts requires Z degrees C water or immersion liquid, with an incremental increase equation identified and maintained by the hardware or software, on a per-component basis within a server chassis or server rack. Other technical advantages exist as well. Embodiments are not limited to these examples.

The technologies described herein may be implemented in one or more electronic devices. Non-limiting examples of electronic devices that may utilize the technologies described herein include any kind of mobile device and/or stationary device, such as microelectromechanical systems (MEMS) based electrical systems, gyroscopes, advanced driving assistance systems (ADAS), fifth generation (5G) and sixth generation (6G) communication systems, cameras, cell phones, computer terminals, desktop computers, electronic readers, facsimile machines, kiosks, netbook computers, notebook computers, internet devices, payment terminals, personal digital assistants, media players and/or recorders, servers (e.g., blade server, rack mount server, combinations thereof, etc.), set-top boxes, smart phones, tablet personal computers, ultra-mobile personal computers, wired telephones, combinations thereof, and the like. Such devices may be portable or stationary. In some embodiments, the technologies described herein may be employed in a desktop computer, laptop computer, smart phone, tablet computer, netbook computer, notebook computer, personal digital assistant, server, combinations thereof, and the like. More generally, the technologies described herein may be employed in any of a variety of electronic devices, including semiconductor packages having cold plates and manifolds over package substrates that have a plurality of semiconductor dies, where each semiconductor die is cooled with one or more liquid cooling paths.

As used herein the terms "top," "bottom," "upper," "lower," "lowermost," and "uppermost" when used in relationship to one or more elements are intended to convey a relative rather than absolute physical configuration. Thus, an element described as an "uppermost element" or a "top element" in a device may instead form the "lowermost element" or "bottom element" in the device when the device is inverted. Similarly, an element described as the "lowermost element" or "bottom element" in the device may instead form the "uppermost element" or "top element" in the device when the device is inverted.

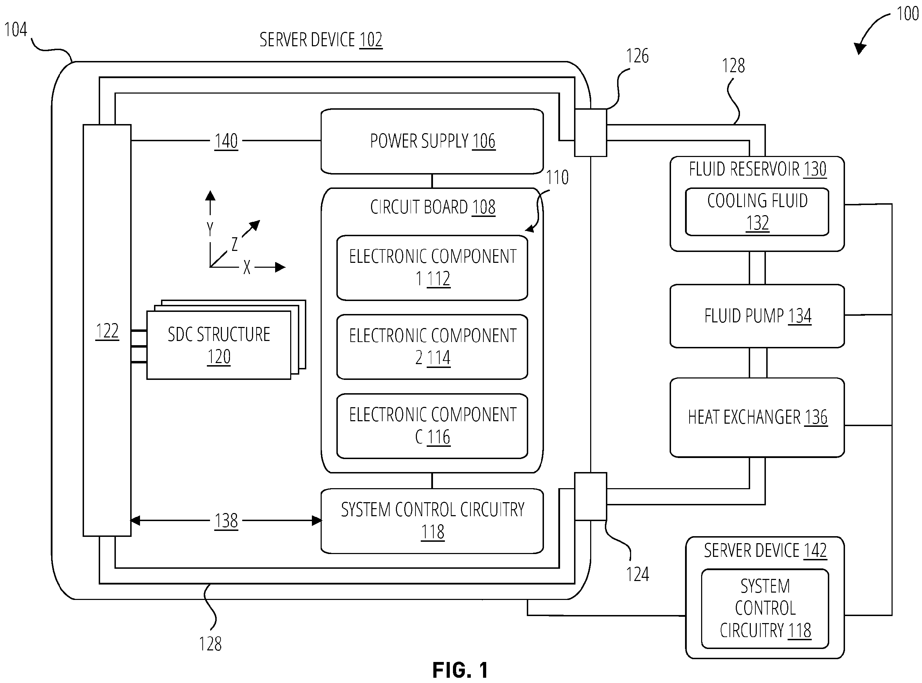

FIG. 1 illustrates a cooling system 100 for an electronic device. For example, the cooling system 100 implements various cooling technologies to cool various electronic components of a server device 102.

Various embodiments are generally directed to software defined cooling (SDC) structures for a cooling system 100 of an electronic device. A non-limiting example of an electronic device is a server device 102, such as a server blade having a form factor suitable for insertion into a server rack of a data center, such as a cloud compute data center or an edge system. Some embodiments are particularly directed to precision delivery of cooling and power resources across different spatial areas of the server device 102. Additionally, or alternatively, the cooling system 100 may be used to cool other electronic devices as previously described. Embodiments are not limited in this context.

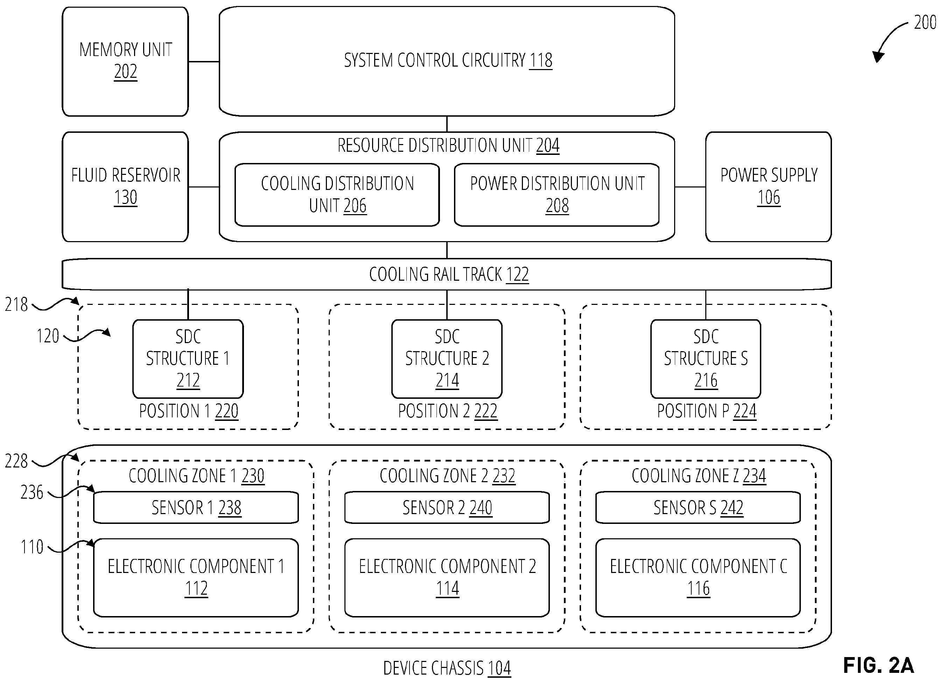

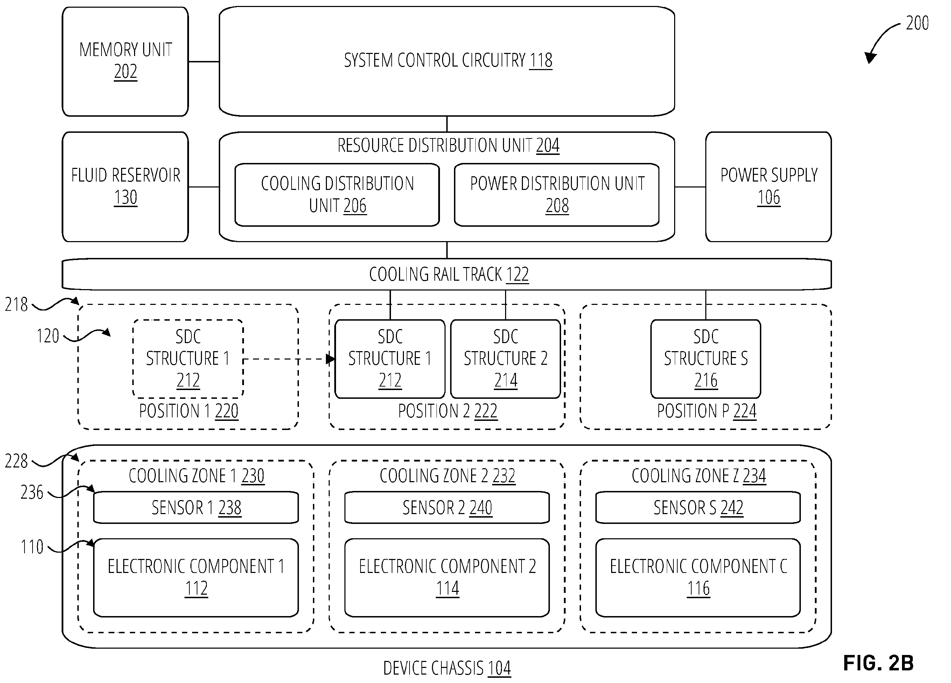

In one embodiment, for example, the server device 102 comprises a device chassis 104 housing different electronic components 110. The interior of the device chassis 104 is divided into one or more sections, referred to as cooling zones, as described in more detail with reference to FIG. 2A and FIG. 2B. A cooling zone is a defined spatial area within the device chassis 104. The defined area may be a two-dimensional (2D) area or a three-dimensional (3D) area within the device chassis 104. Each cooling zone includes one or more electronic components 110. For example, a first cooling zone includes a power supply 106, a second cooling zone includes a set of electronic components 110 (e.g., semiconductor devices such as XPUs, memory units, controllers, etc.) mounted on a circuit board 108 (e.g., a printed circuit board (PCB)), a third cooling zone includes a storage device, a fourth cooling zone includes a network interface card (NIC), and so forth. Each cooling zone includes one or more sensors. One or more SDC structures 120 are mounted on a cooling rail track 122. A system control circuitry 118 generates a control directive 138 to cause the cooling rail track 122 to move one or more of the SDC structures 120 to the different cooling zones to deliver precision cooling to the electronic components 110 within the different cooling zones based on sensor data, instantaneous workloads of the electronic components 110, or predicted workloads for the electronic components 110.

As depicted in FIG. 1, the server device 102 comprises a device chassis 104 encapsulating a power supply 106, a circuit board 108, a set of electronic components 110 mounted on the circuit board 108, and a system control circuitry 118. The server device may include more or less components depending on a particular implementation. For example, some embodiments may implement platform components, interfaces, network interface cards, interconnects such as Peripheral Component Interconnect Express (PCIe) and Compute Express Link (CXL), and so forth. Embodiments are not limited in this context.

The system control circuitry 118 controls operations for the cooling system 100. In one embodiment, for example, the server device 102 using the cooling system 100 implements the system control circuitry 118. In one embodiment, for example, a server device 142 separate from the server device 102 controls the cooling system 100 for the server device 102. For example, the server device 142 may control the cooling system 100 for multiple server devices 102 for a data center, such as a cloud compute data center or an edge system.

The cooling system 100 implements various cooling technologies to cool the set of electronic components 110, such as electronic component 1 112, electronic component 2 114, and electronic component C 116, where C represents any positive integer. Specifically, the cooling system 100 is designed to offer precision cooling to specific parts, components, or cooling zones of the server device 102 using one or more SDC structures 120 attached to a motion control system. The motion control system allows for automated or controlled movement of the SDC structures 120 within the device chassis 104. For example, the motion control system automatically adjusts a position of the SDC structures 120 closer to higher temperature components during peak loads or retracts them for power saving and reduced noise when the system is under lighter loads. The motion control system dynamically manages a physical component layout or topology for the SDC structures 120, leading to optimized cooling performance, easier maintenance, and potentially longer hardware lifespans for the electronic components 110.

The SDC structures 120 may comprise internal cooling components designed to implement any number of cooling technologies for thermal management or cooling of the electronic components 110. Cooling technologies for electronic components 110 within the server device 102 encompass a variety of methods designed to dissipate heat and maintain optimal operational temperatures. Non-limiting examples of these technologies include air cooling, liquid cooling, heat pipes, phase change material (PCM) cooling, thermoelectric cooling, and immersion cooling. For instance, an SDC structure 120 may implement air cooling utilizing fans, blowers, or refrigerants to circulate cold air across the electronic components 110 or heat sinks/cold plates attached to electronic components 110, facilitating heat dissipation. In another example, an SDC structure 120 may be a cooling head or cooling drop for liquid cooling systems using a coolant liquid which circulates through a loop, absorbing heat from the components before being cooled down in a radiator. In yet another example, an SDC structure 120 may comprise heat pipes for conducting heat away from the electronic components 110 to a cooler area where it can be dissipated more efficiently, such as an external cooling component for the server device 102. In another example, an SDC structure 120 may implement a heat sink or a cold plate to physically touch an electronic component 110. In yet another example, an SDC structure 120 may comprise a vacuum pump to suck heated air away from an electronic component 110. In another example, an SDC structure 120 may use a form of PCM cooling that leverages materials that absorb heat as they change from solid to liquid, effectively regulating component temperatures. In still another example, an SDC structure 120 may implement thermoelectric cooling that employs the Peltier effect to create a heat flux between the junction of two different types of materials, allowing for cooling below ambient temperature. In another example, an SDC structure 120 may implement a form of immersion cooling that involves spraying liquid coolant on an electronic component 110, or submerging some or all of an electronic component 110 in a non-conductive liquid that dissipates heat effectively. Embodiments are not limited to these examples.

Each of these cooling technologies offer distinct advantages and are selected based on specific requirements such as cooling capacity, energy efficiency, space constraints, and the thermal management needs of the electronic device. Air and liquid cooling systems are widely used for their balance of efficiency and cost-effectiveness, suitable for a vast range of electronic devices from consumer electronics to server farms. Heat pipes and PCM cooling are noted for their passive cooling capabilities, making them ideal for applications where minimal maintenance is desired. Thermoelectric coolers, while less commonly used due to their higher energy consumption, offer precise temperature control. Immersion cooling, considered an advanced solution, is gaining popularity in data centers and high-performance computing applications due to its superior cooling efficiency and potential for space savings. Ultimately, selection of a particular cooling technology is dependent on such design factors as reliability, performance requirements, and longevity of the SDC structures 120 and/or electronic components 110 in various applications.

In various embodiments, a motion control system controls movement of the SDC structures 120 throughout the interior of the device chassis 104 to offer precision cooling to specific parts, components, or cooling zones of the server device 102. An SDC structure 120 is a movable internal cooling component of the server device 102. One or more of the SDC structures 120 are attached to the motion control system in the server device 102. The motion control system comprises a combination of mechanical, electrical, and/or electro-mechanical parts, such as electrical motors, gears, rails, levers, rotators, and control electronics designed to accurately move and position parts, components, or structures within the server device 102. The specific configurations and mechanisms depend on the movement requirements, such as linear or rotary motion, the force needed, and the precision of positioning. Non-limiting examples of a motion control system suitable or adaptable for moving the SDC structures 120 within the device chassis 104 include: (1) robotic arms such as those used by surgical robots or automotive robots to manipulate objects with high precision, flexibility, and degrees of freedom; (2) computer numerical control (CNC) machines in manufacturing to guide tools (e.g., drills, lathes, and mills) along complex paths with precise control over speed and position; (3) linear actuators to provide straight-line motion allowing for precise control over speed, position, and force; (4) 2D or 3D precision rails that guide the linear motion facilitated by the actuators, ensuring smooth and stable movement within the confined space of the server chassis; and (5) systems to control movement of print heads to create 3D objects in a 3D printer. Embodiments are not limited to these examples.

In one embodiment, for example, the SDC structure 120 is mounted to a cooling rail track 122. The cooling rail track 122 is an electro-mechanical component with an electric drive and a mechanical actuator such as an articulated robotic arm that is capable of moving the SDC structure 120 in different 2D or 3D directions to different positions throughout the spatial interior of the device chassis 104. For example, the cooling rail track 122 is capable of moving the SDC structures 120 in an X, Y, or Z direction according to a set of coordinates corresponding to a 2D or 3D coordinate system, such as a Cartesian coordinate system. The system control circuitry 118 can generate control directives with 2D or 3D coordinates for the cooling rail track 122 to cause the cooling rail track 122 to move the SDC structure 120 to reach different parts, components, or cooling zones within the interior of the device chassis 104 of the server device 102 to precisely increase or decrease an amount of cooling for the electronic components 110 on an as-needed basis. The system control circuitry 118 may execute a binary to monitor telemetry data from a set of sensors, such as temperature sensors, to generate the control directives. The SDC structure 120 is designed to implement different cooling techniques as previously described.

In one embodiment, for example, the cooling system 100 implements a liquid cooling system for delivery through the one or more SDC structures 120. The cooling system 100 includes a fluid reservoir 130 to store a cooling fluid 132. A fluid pump 134 pumps the cooling fluid 132 from the cooling fluid 132 through a fluid pipe 128 to a heat exchanger 136. The heat exchanger 136 is connected to an ingress port 124 for the device chassis 104. The fluid pump 134 pumps the cooling fluid 132 through the heat exchanger 136 and the ingress port 124 to a cooling rail track 122 of the server device 102. The cooling rail track 122 connects to an egress port 126 of the device chassis 104. The egress port 126 is connected to the fluid reservoir 130. In operation, the cooling system 100 circulates the cooling fluid 132 through a cooling loop, which traverses the cooling rail track 122 and the SDC structure 120, absorbing heat from the electronic components 110 before being cooled down by the heat exchanger 136.

Specifically, the cooling system 100 may include one or more fluid reservoirs 130. The fluid reservoir 130 is a component that holds the cooling fluid 132 or coolant. The primary purpose of the fluid reservoir 130 is to maintain an adequate volume of cooling fluid 132 within the cooling system 100, ensuring that there is always enough cooling fluid 132 to circulate and efficiently transfer heat away from the components being cooled, such as the electronic components 110. The fluid reservoir 130 acts as a storage tank for the cooling fluid 132, providing a buffer of cooling fluid 132 that can be drawn into the cooling loop as needed. This is particularly important during system start-up or when any part of the system needs additional coolant due to evaporation or leakage. The fluid reservoir 130 also provides a convenient point for adding or replacing coolant in the system. It allows for easy access to the fluid for maintenance purposes, such as flushing the system or replenishing coolant levels. The fluid reservoir 130 helps in removing air bubbles from the cooling fluid 132. Air bubbles can significantly reduce the efficiency of heat transfer and can cause noise in the system. The design of the fluid reservoir 130 allows air bubbles to rise out of the circulating cooling fluid 132 and collect at the top, away from the main flow, where they can be vented outside the system. Having a fluid reservoir 130 can also assist in temperature stabilization. The volume of cooling fluid 132 in the fluid reservoir 130 provides a thermal buffer that can absorb and dissipate heat, helping to moderate temperature fluctuations within the system. It can also serve to relieve pressure within the cooling system. As the cooling fluid 132 heats up and expands, the fluid reservoir 130 accommodates the increased volume, preventing excessive pressure build-up that could lead to leaks or damage to system components. The fluid reservoir 130 can come in various sizes and designs, ranging from simple closed tanks to sophisticated pressurized containers, depending on system requirements and the specific applications.

The fluid reservoir 130 holds or stores cooling fluid 132. A cooling fluid 132 may transfer heat from the electronic components 110 to the heat exchanger 136 which dissipates heat from the heated liquid into the ambient, or another separate liquid cooling component or system. Examples of cooling fluids 312 include engineered fluids such as 3M^{™} Novec^{™} and Fluorinert^{™}, synthetic oils, and specially formulated dielectric fluids. In one embodiment, for example, the cooling fluid 312 flowing through the liquid cooling path 314 is a non-electric-conductive, non-ionic, and non-reactive liquid (e.g., a fluorinated liquid). In another embodiment, the fluid may be water when the semiconductor die 104 is surrounded with an insulated material. In some embodiments, the cooling fluid 312 may be a fluorinated liquid type and/or a freon liquid type. Examples of a fluorinated liquid type may include without limitation FC-3283, FC-40, FC-43, FC-72, FC-75, FC-78, and FC-88. In one embodiment, for example, the freon liquid type may include freon-C-51-12, freon-E5, or freon-TF. Embodiments are not limited to these examples.

Two parameters of cooling fluid 132 to consider when choosing a cooling fluid 132 for use in a particular cooling implementation are its flammability and global warming potential (GWP) number, with a lower GWP number indicating that a material contributes less to global warming. Some synthetic single-phase cooling liquids (e.g., Novec fluids) have good thermal performance but also have a high GWPs. As there are worldwide efforts to phase out the use of greenhouse gases, such as hydrofluorocarbons, there is interest in using non-GWP or low-GWP materials (e.g., materials having a GWP<1) where possible. The liquid cooling technologies disclosed herein can provide for the liquid cooling of electronic devices and systems comprising high-performance IC components using non-flammable and/or non-GWP or low-GWP fluids. The use of such technologies can aid large cloud service providers (CSPs), high-performance computing (HPC) system vendors, and other entities that may begin to increasingly rely on liquid cooling in data centers to meet defined environmental sustainability (e.g., carbon-neutral, carbon-negative) goals.

The cooling system 100 may include one or more pumps, such as fluid pump 134. A pump is a component responsible for circulating the cooling fluid 132 throughout the fluid pipe 128 of the cooling system 100. It propels the cooling fluid 132 through fluid pipes 128, tubes, and other components such as the heat exchanger. The fluid pump 134 enables the cooling system 100 to efficiently transfer heat away from the heat source, through cooling fluid 132, and towards the heat exchanger 136 where the heat can be dissipated into the environment, thus maintaining optimal operating temperatures. Non-limiting examples of pumps include centrifugal pumps, submersible pumps, inline pumps, diaphragm pumps, and so forth. The choice of pump in the cooling system 100 depends on various factors, including cooling requirements, the thermal load it needs to manage, the layout and size of the cooling loop, and considerations like noise, efficiency, and maintenance.

The cooling system 100 may include one or more heat exchangers 136. A heat exchanger 136 is a component designed to dissipate heat away from the cooling system 100 to maintain optimal operating temperatures. The operation involves the heated cooling fluid 132 flowing into one side of the heat exchanger from the fluid pump 134, while the cooling fluid 132 flows out the other side to the ingress port 124. The design of the heat exchanger 136 facilitates a large surface area for the heat to transfer across the barrier separating the two fluids. The thermal energy from the hot side is absorbed by the cooler side, effectively removing heat from the system. Non-limiting examples for the heat exchanger 136 includes: (1) a radiator that allows the heated cooling fluid 132 to flow through fins or tubes where it is cooled by air flowing through the radiator aided by a cooling fan; (2) a plate heat exchanger comprising multiple, thin, slightly separated plates that have large surface areas and fluid flow passages for heat transfer; (3) a shell and tube heat exchanger using a series of tubes, where one set carries the heated cooling fluid 132, while the other set carries a cooling medium; (4) a micro-channel heat exchanger that utilizes many small channels through which the heated cooling fluid 132 flows. The choice of heat exchanger 136 in the cooling system 100 depends on various factors including the required heat transfer efficiency, space constraints, the type of fluids involved, and the temperature range within which the system operates.

The cooling system 100 includes a set of valves at the ingress port 124 and the egress port 126 of the device chassis 104. A valve is a mechanical device that controls the flow of the cooling fluid 132 and the heated cooling fluid 132 through the fluid pipe 128. It can adjust the flow rate, direct the flow path, or completely stop the flow, depending on the operational requirements of the system. Non-limiting examples of valves include ball valves, gate valves, globe valves, check valves, solenoid valves, needle valves, and so forth. In one embodiment, for example, the valves are implemented as solenoid valves, which are electrically controlled valves that can open or close the flow of liquid coolant in response to an electrical signal from a controller, thereby offering precise control over the cooling system 100.

FIG. 2A illustrates a cooling system 200. The cooling system 200 is a more detailed example of an architecture suitable for the cooling system 100.

As depicted in FIG. 2A, the cooling system 200 comprises a system control circuitry 118. The system control circuitry 118 is circuitry to execute instructions, such as executable code of a binary, to control operations for the cooling system 200. The system control circuitry 118 may access the instructions from a memory unit 202 for execution by the system control circuitry 118. Additionally, or alternatively, the system control circuitry 118 may be implemented as hardware, such as an application specific integrated circuit (ASIC) or a fieldprogrammable gate array (FPGA). Embodiments are not limited in this context.

The cooling system 200 comprises a resource distribution unit 204. The resource distribution unit 204 controls distribution of resources for the cooling system 200. For example, the resource distribution unit 204 comprises a cooling distribution unit 206 to manage distribution of the cooling fluid 132 from the fluid reservoir 130 to the SDC structures 120, such as SDC structure 1 212, SDC structure 2 214, and SDC structure S 216, where S represents any positive integer. The resource distribution unit 204 further comprises a power distribution unit 208 to manage distribution of power from the power supply 106 to the SDC structures 120 and/or the electronic components 110.

As previously discussed, the server device 102 is divided into one or more cooling zones 228, such as cooling zone 1 230, cooling zone 2 232, and cooling zone Z 234, where Z represents any positive integer. A cooling zone is a defined area within the device chassis 104. The defined area may be a 2D area or a 3D area within the device chassis 104. Each cooling zone 228 includes one or more electronic components 110. For example, the cooling zone 1 230 includes an electronic component 1 112, the cooling zone 2 232 includes an electronic component 2 114, and the cooling zone Z 234 includes an electronic component C 116. Further, each cooling zone 228 includes one or more sensors 236. One or more SDC structures 120, such as SDC structure 1 212, SDC structure 2 214, and SDC structure S 216, where P represents any positive integer, are mounted on a cooling rail track 122. The cooling rail track 122 is capable of moving the SDC structures 120 in a 2D or 3D coordinate space between various positions 218, such as position 1 220, position 2 222, and position P 224, where P represents any positive integer. Each of the positions 218 are within a defined distance from the cooling zones 228 and/or the electronic components 110. The defined distance is a configurable parameter based on a type of cooling technique implemented for each of the SDC structures 120. In some cases, the defined distance is zero which means the SDC structure 120 makes actual physical contact with the electronic component 110.

A system control circuitry 118 generates a control directive 138 to cause the cooling rail track 122 to move one or more of the SDC structures 120 between positions 218 proximate to the different cooling zones 228 to deliver precision cooling to the electronic components 110 within the different cooling zones 228 based on sensor data from the sensors 236, instantaneous workloads of the electronic components 110, or predicted workloads for the electronic components 110.

In one embodiment, for example, the system control circuitry 118 receives and decodes sensor data (or telemetry data) from a sensor 236 of a cooling zone 228 or an electronic component 110 of the server device 102. The sensors 236 may monitor various properties and attributes of the cooling system 100 or cooling system 200 to ensure efficient operation, safety, and performance monitoring. For example, the sensors 236 may include temperature sensors designed to measure the temperature of the liquid coolant and components being cooled, such as the electronic components 110. Common types of temperature sensors include thermocouples, thermistors, and resistance temperature detectors (RTDs). The sensors 236 may include flow sensors designed to measure a flow rate of the cooling fluid 132 in the system, ensuring it is circulating properly. Examples include turbine flow sensors, ultrasonic flow sensors, and paddlewheel sensors. The sensors 236 may include pressure sensors designed to measure the pressure of the cooling fluid 132 within the cooling system 100 or cooling system 200. This is important for detecting leaks, blockages, or pump failures. Common types include piezoelectric pressure sensors and strain gauge pressure sensors. The sensors 236 may include level sensors designed to detect a coolant level within the fluid reservoir 130, ensuring the system has enough cooling fluid 132 to function properly. Types include capacitive level sensors, ultrasonic level sensors, and float level sensors. The sensors 236 may include pH sensors designed to monitor an acidity or alkalinity of the cooling fluid 132 to prevent corrosion-related damage. The sensors 236 may include conductivity sensors designed to measure the electrical conductivity of the cooling fluid 132. This can be important for detecting contamination or the concentration of additives in the cooling fluid 132. The sensors 236 may include temperature difference sensors designed to measure a temperature difference across the cooling system to assess its efficiency. Each of the sensors 236 plays a role in monitoring and controlling a liquid cooling system, contributing to its effectiveness and longevity. Embodiments are not limited to these examples.

The system control circuitry 118 analyzes the sensor data (or telemetry data), and it generates a control directive 138 to move an SDC structure 120 of the cooling system 100 from a first position 1 220 to a second position 2 222 based on the sensor data. The cooling rail track 122 receives the control directive 138, and it moves the SDC structure 120 from the first position 1 220 to the second position 2 222 in response to the control directive 138. For example, the second position 218 may comprise a position within a defined distance to the electronic component 110 of the server device 102 so the SDC structure 120 can perform thermal management for the electronic component 110 using the SDC structure 120. For example, the first position 218 and the second position 218 represent numerical coordinates in a 3D coordinate system, such as a Cartesian coordinate system, which are interpretable by the cooling rail track 122. For example, the first position 218 is located in or near a first cooling zone 228 and the second position 218 is located in or near a second cooling zone 228.

In one embodiment, for example, the system control circuitry 118 is arranged to access configuration data for a cooling zone 228 where the electronic component 110 is located. The configuration data may include, for example, a volumetric area for the cooling zone 228, an SLO defined by an SLA defining an operating target for the cooling zone 228, a priority level associated with the cooling zone 228, reservation data for the cooling zone 228, and other parameters.

In one embodiment, for example, the system control circuitry 118 is arranged to decode sensor data from a sensor 236 that the SDC structure 120 is located at the second position 218. The system control circuitry 118 analyzes the sensor data, and it generates a control directive 138 to initiate cooling operations of the SDC structure 120 to reduce a temperature of the electronic component 110 by the SDC structure 120. For example, the system control circuitry 118 is arranged to generate the control directive 138 to move the SDC structure 120 of the cooling system 200 from the first position 218 to the second position 218 based on the sensor data and the configuration data associated with the cooling zone 228, such as the volumetric area for the cooling zone 228, the SLA for the cooling zone 228, the priority level associated with the cooling zone 228, or the reservation data for the cooling zone 228. The system control circuitry 118 iteratively and dynamically moves the SDC structures 120 to the electronic components 110 in need of thermal management.

FIG. 2B illustrates the cooling system 200 in a different configuration. As discussed with reference to FIG. 2A, the system control circuitry 118 receives and decodes sensor data from a sensor 236 of an electronic component 110 of the server device 102. The system control circuitry 118 analyzes the sensor data (or telemetry data), and it generates a control directive 138 to move an SDC structure 120 of the cooling system 100 from a first position 1 220 to a second position 2 222 based on the sensor data. For example, the sensor data from the sensor 2 240 may indicate that the electronic component 2 114 in the cooling zone 2 232 is approaching a thermal limit and requires additional cooling beyond the capabilities of the SDC structure 2 214.

An electronic component 110, such as a semiconductor die, is designed to operate within a set of temperature operating ranges, referred to as a dynamic temperature range (DTR), as defined by one or more specifications. A non-limiting example of a specification is an External Design Specification (EDS). An original equipment manufacturer (OEM), an original device manufacturer (ODM), and/or a device end-user may define different EDS, or different parameters for an EDS, of a given electronic component 110. A non-limiting example of an EDS defining a DTR for an electronic component 110 is as follows: "For a single operational cycle, the processor shall execute at full data sheet performance across the full Dynamic Temperature Range (DTR) without resetting or retraining, where the processor DTR is a personal computer (PC) client stock keeping unit (SKU) is plus or minus 70°C and an embedded and industry SKU is plus or minus 90°C."

A DTR is a range of silicon junction temperatures (Tj) within which the electronic component 110 is able to execute full performance in a single power cycle, between a startup temperature and a final operating temperature. The DTR is not necessarily a thermal requirement, but rather is a package reliability requirement. The DTR defines an operating range for the electronic component 110 ranging from a minimum boot temperature (Tboot_min) to a maximum boot temperature (Tboot_max). As long as the Tj of the electronic component 110 remains within Tboot_min and Tboot_max of the operating range, the electronic component 110 should operate within device specifications and not experience any thermallyrelated operational issues.

By way of example, an OEM may define a first operating range of silicon junction temperatures (Tj) between a minimum silicon temperature (Tj_min) to a maximum silicon temperature (Tj_max). An ODM or an end-user may define a second operating range of silicon junction temperatures (Tj) during a boot-up phase, such as between a minimum boot temperature (Tboot_min) and a maximum boot temperature (Tboot_max). It is worthy to note that the second operating range of the electronic component 110 is typically a smaller range of Tj relative to the first operating range. A set of guard ranges are defined between the first operating range and the second operating range. The guard ranges represent a guard between Tj_min and TJ_max to ensure continuous operations of the electronic component 110 within the server device 102.

Continuing with the previous example, the sensor data from the sensor 2 240 may indicate that the electronic component 2 114 in the cooling zone 2 232 is approaching a DTR limit and requires additional cooling beyond the cooling capabilities of the SDC structure 2 214. The system control circuitry 118 generates the control directive 138 to move the SDC structure 1 212 of the cooling system 100 from a first position 1 220 to a second position 2 222 based on the sensor data. The cooling rail track 122 receives the control directive 138, and it moves the SDC structure 120 from the first position 1 220 to the second position 2 222 in response to the control directive 138. As depicted in FIG. 2B, the cooling rail track 122 moves the SDC structure 1 212 from position 1 220 proximate to cooling zone 1 230 to position 2 222 proximate to cooling zone 2 232. Subsequent to this movement, the SDC structure 1 212 and the SDC structure 2 214 are now in position 2 222 so that they can, in combination, deliver a greater amount of cooling to the electronic component 2 114 in the cooling zone 2 232.

The system control circuitry 118 is arranged to decode sensor data from the sensor 2 240 that the SDC structure SDC structure 1 212 is located at the second position 218. The system control circuitry 118 analyzes the sensor data, and it generates a control directive 138 to initiate cooling operations of the SDC structure 1 212, the SDC structure 2 214, or both the SDC structure 1 212 and the SDC structure 2 214, to reduce a temperature of the electronic component electronic component 2 114 by the SDC structure 1 212 and/or the SDC structure 2 214. For example, the system control circuitry 118 is arranged to generate the control directive 138 to move the SDC structure 1 212 of the cooling system 200 from the first position 218 to the second position 218 based on the sensor data and the configuration data associated with the cooling zone 2 232, such as the volumetric area for the cooling zone 2 232, the SLA for the cooling zone 2 232, the priority level associated with the cooling zone 2 232, or the reservation data for the cooling zone cooling zone 2 232.

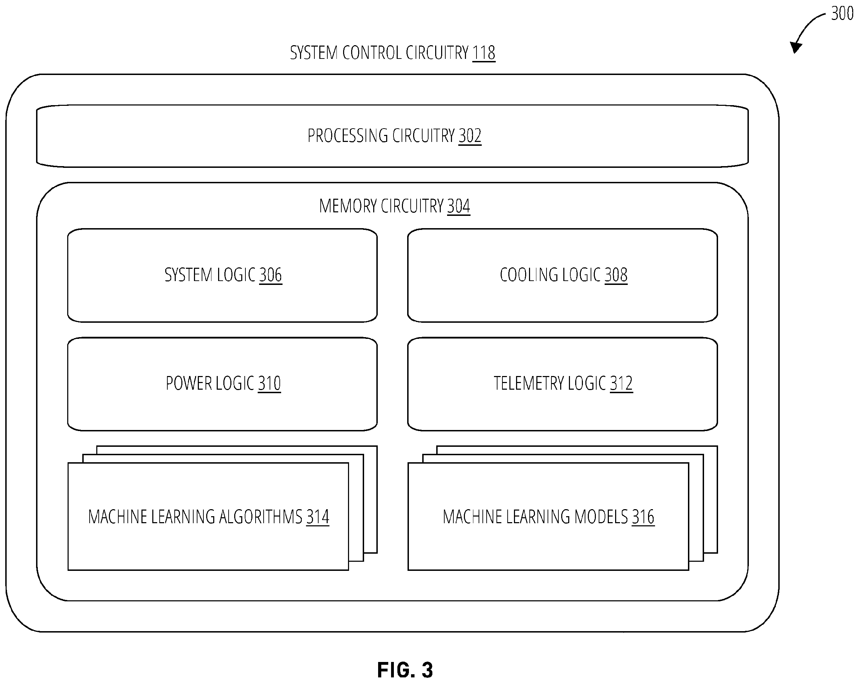

FIG. 3 illustrates an apparatus 300. The apparatus 300 comprises an example implementation for the system control circuitry 118.

As depicted in FIG. 3, the system control circuitry 118 of the apparatus 300 comprises processing circuitry 302 and memory circuitry 304. The memory circuitry 304 comprises a set of executable instructions for various logic blocks, such as system logic 306, cooling logic 308, power logic 310, and telemetry logic 312. The memory circuitry 304 also stores executable instructions for one or more ML algorithm 314 to train one or more ML model 316.

The system logic 306 controls or manages overall system operations for the cooling system 100 and/or the cooling system 200. This includes operations such as generating configuration data for the cooling zones 228 of the server device 102, decoding sensor data from the sensors 236, analyzing sensor data based on the configuration data, predicting DTR limits for the electronic component 110, and so forth. The system logic 306 also generates control directives 138 to control cooling operations and power operations for the resource distribution unit 204, the cooling rail track 122, the SDC structures 120, and the electronic components 110. For example, the system logic 306 generates control directives 138 to move the SDC structures 120 between positions 218 to apply precision cooling to the electronic components 110 within the cooling zones 228.

The cooling logic 308 controls or manages cooling operations for the cooling distribution unit 206 of the resource distribution unit 204. The cooling logic 308 receives the control directives 138 from the system logic 306, and it controls distribution of the cooling fluid 132 from the fluid reservoir 130 to the SDC structures 120. For example, the cooling logic 308 may increase an amount of cooling fluid 132 delivered to the SDC structure 120, decrease an amount of cooling fluid 132 delivered to the SDC structure 120, modify a type of cooling fluid 132 used by the SDC structure 120, drain some or all of the cooling fluid 132 from the SDC structure 120, and so forth.

The power logic 310 controls or manages power operations for the power distribution unit 208 of the resource distribution unit 204. The power logic 310 receives the control directive 138 from the system logic 306, and it controls distribution of power from the power supply 106 to the SDC structures 120 and/or the electronic components 110. For example, the power logic 310 may increase an amount of power delivered to the SDC structure 120 to increase cooling operations, decrease an amount of power delivered to the SDC structure 120 to decrease cooling operations, increase on amount of power delivered to the electronic component 110 to increase compute operations for the electronic component 110, decrease an amount of power delivered to the electronic component 110 to decrease compute operations for the electronic component 110, turn on or off an SDC structure 120, turn on or off the electronic component 110, and so forth.

The telemetry logic 312 controls or manages operations for the sensors 236 disposed within the cooling zones 228. The telemetry logic 312 manages system telemetry data for the server device 102, which includes the automated collection, transmission, and analysis of sensor data regarding the performance, health, and behavior of the computing devices, software, interconnects, and networks that constitute the server device 102. This data is used for monitoring, managing, and optimizing system performance and ensuring the reliability and security of device operations.

The system control circuitry 118 may implement a set of AI or ML techniques to assist in managing the cooling system 100 and the cooling system 200. For example, the system control circuitry 118 may implement one or more ML algorithm 314 to train one or more ML model 316 to configure or re-configure the cooling zones 228 and the positions 218 for the SDC structures 120, generate the DTR limits for the electronic components 110, predict when the electronic components 110 are approaching DTR limits, calculating cooling capacity of the SDC structures 120, calculating cooling requirements for the electronic components 110, and other downstream tasks.

The system control circuitry 118 may implement one or more ML algorithm 314. For example, the system control circuitry 118 may implement one or more lambda functions. A lambda function is a relatively small, anonymous function defined with the lambda keyword in programming languages like Python. It is often used in machine learning code for conciseness and flexibility, especially in data manipulation and feature engineering phases. A lambda function in Python allows the function to take any number of arguments but comprises only one expression, the result of which is returned by the function. In machine learning, Lambda functions are frequently used in data preprocessing steps to apply transformations to data elements. For example, a lambda function may convert temperatures from Celsius to Fahrenheit across a dataset. When creating or modifying features in a dataset, lambda functions can apply quick, inline calculations or transformations without the need for defining a separate, named function. Lambda functions are often used with map(), filter(), and reduce() functions to apply operations on lists or columns in a Data Frame. For instance, applying a lambda function to scale a numerical feature in a pandas Data Frame column.

The system control circuitry 118 may implement the lambda functions to pre-process data from various logic or components of the server device 102 or multiple server device 102 using the cooling system 100 or the cooling system 200. The output of the lambda functions is a training dataset suitable for training an ML model, such as the ML model 316. In some cases, the system control circuitry 118 may employ a set of filters to filter the output from the lambda functions to limit the output to a dataset suitable for inclusion in the training dataset, and outputs the training dataset for use by the system control circuitry 118. For example, the system control circuitry 118 of the server device 102 may output the training dataset to the server device 142 of a cloud compute data center or an edge system to train the ML model 316.

A cloud compute data center comprises a set of servers, such as a server pool or server farm, as represented by the server device 142. The server device 142 executes ML algorithm 314 to train ML model 316 using the training dataset. Once the ML model 316 is trained, the server device 142 uses the trained ML model, or sends the trained ML model to the server device 102, for deployment as prediction logic to perform inferencing operations to support the cooling logic 308.

The ML model 316 is a mathematical construct used to predict outcomes based on a set of input data. The ML model 316is trained using large volumes of training data from the training dataset, and it can recognize patterns and trends in the training data to make accurate predictions. The ML model 316 is derived from an ML algorithm 314. The training dataset is fed into the ML algorithm 314 which trains the ML model 316 to "learn" a function that produces mappings between a set of inputs and a set of outputs with a reasonably high accuracy. Given a sufficiently large enough set of inputs and outputs, the ML algorithm 314 finds the function for a given task. This function may even be able to produce the correct output for input that it has not seen during training. A data scientist prepares the mappings, selects and tunes the ML algorithm 314, and evaluates the resulting model performance. Once the ML model 316 is sufficiently accurate on test data, it can be deployed for production use.

The ML algorithm 314 may comprise any ML algorithm suitable for a given AI task. Examples of ML algorithms may include supervised algorithms, unsupervised algorithms, semi-supervised algorithms, or reinforcement learning algorithms.

A supervised algorithm is a type of machine learning algorithm that uses labeled data to train a machine learning model. In supervised learning, the machine learning algorithm is given a set of input data and corresponding output data, which are used to train the model to make predictions or classifications. The input data is also known as the features, and the output data is known as the target or label. The goal of a supervised algorithm is to learn the relationship between the input features and the target labels, so that it can make accurate predictions or classifications for new, unseen data. Examples of supervised learning algorithms include: (1) linear regression which is a regression algorithm used to predict continuous numeric values, such as stock prices or temperature; (2) logistic regression which is a classification algorithm used to predict binary outcomes, such as whether a customer will purchase or not purchase a product; (3) decision tree which is a classification algorithm used to predict categorical outcomes by creating a decision tree based on the input features; or (4) random forest which is an ensemble algorithm that combines multiple decision trees to make more accurate predictions.

An unsupervised algorithm is a type of machine learning algorithm that is used to find patterns and relationships in a dataset without the need for labeled data. Unlike supervised learning, where the algorithm is provided with labeled training data and learns to make predictions based on that data, unsupervised learning works with unlabeled data and seeks to identify underlying structures or patterns. Unsupervised learning algorithms use a variety of techniques to discover patterns in the data, such as clustering, anomaly detection, and dimensionality reduction. Clustering algorithms group similar data points together, while anomaly detection algorithms identify unusual or unexpected data points. Dimensionality reduction algorithms are used to reduce the number of features in a dataset, making it easier to analyze and visualize. Unsupervised learning has many applications, such as in data mining, pattern recognition, and recommendation systems. It is particularly useful for tasks where labeled data is scarce or difficult to obtain, and where the goal is to gain insights and understanding from the data itself rather than to make predictions based on it.

Semi-supervised learning is a type of machine learning algorithm that combines both labeled and unlabeled data to improve the accuracy of predictions or classifications. In this approach, the algorithm is trained on a small amount of labeled data and a much larger amount of unlabeled data. The main idea behind semi-supervised learning is that labeled data is often scarce and expensive to obtain, whereas unlabeled data is abundant and easy to collect. By leveraging both types of data, semi-supervised learning can achieve higher accuracy and better generalization than either supervised or unsupervised learning alone. In semi-supervised learning, the algorithm first uses the labeled data to learn the underlying structure of the problem. It then uses this knowledge to identify patterns and relationships in the unlabeled data, and to make predictions or classifications based on these patterns. Semi-supervised learning has many applications, such as in speech recognition, natural language processing, and computer vision. It is particularly useful for tasks where labeled data is expensive or timeconsuming to obtain, and where the goal is to improve the accuracy of predictions or classifications by leveraging large amounts of unlabeled data.

Reinforcement Learning is a type of machine learning paradigm that is primarily concerned with how agents ought to take actions in an environment to maximize the cumulative reward. Unlike supervised learning where models are trained on a dataset containing inputs paired with correct outputs, reinforcement learning involves an agent that interacts with its environment to learn the best actions to take in different states through trial and error. In a reinforcement learning system, an agent is the learner or decision-maker that takes actions and the environment is the world through which the agent moves and learns from the consequences of its actions. State is a representation of the current situation of the agent in the environment. The state space can be the set of all possible situations the agent can face. Actions are all the possible moves that the agent can make. The set of actions available can depend on the state. 5. Reward is signal from the environment in response to the agent's action, indicating the value of the action taken. The agent's objective is to maximize the cumulative reward over time. Policy sets a strategy used by the agent, mapping states to actions, that dictates the action an agent takes in a given state. A value function estimates the expected cumulative reward of taking an action in a state, following a particular policy. It helps in evaluating the goodness of each state and deciding the next action. A model is a representation of the environment that can predict how the environment will respond to an agent's actions. In model-based reinforcement learning, the agent uses it to plan by considering future possibilities, while in model-free reinforcement learning, the agent learns exclusively from trial and error. The learning process in RL involves exploration (trying out new actions to discover their effects) and exploitation (using known information to make the best decision). Reinforcement learning algorithms are categorized into various approaches, such as value-based methods, policy-based methods, and actor-critic methods. Value-based methods focus on learning the value function, with Q-Learning being a prominent example. Policy-based methods involve directly learning the policy function that maps states to the optimal actions without requiring a value function. Actor-critic methods combine value-based and policy-based methods by using two models, with one to determine the action to take (actor) and another to evaluate the action (critic). Reinforcement learning is used in a wide range of applications, from game playing and robotics to recommendation systems and autonomous vehicles, where the challenge is to make a sequence of decisions that will lead to an optimal outcome.

The ML algorithm 314 is implemented using various types of ML algorithms including supervised algorithms, unsupervised algorithms, semi-supervised algorithms, reinforcement learning algorithms, or a combination thereof. A few examples of ML algorithms include support vector machine (SVM), random forests, naive Bayes, K-means clustering, neural networks, and so forth. A SVM is an algorithm that can be used for both classification and regression problems. It works by finding an optimal hyperplane that maximizes the margin between the two classes. Random forests is a type of decision tree algorithm that is used to make predictions based on a set of randomly selected features. Naive Bayes is a probabilistic classifier that makes predictions based on the probability of certain events occurring. K-Means Clustering is an unsupervised learning algorithm that groups data points into clusters. Neural networks is a type of machine learning algorithm that is designed to mimic the behavior of neurons in the human brain. Other examples of ML algorithms include a support vector machine (SVM) algorithm, a random forest algorithm, a naive Bayes algorithm, a K-means clustering algorithm, a neural network algorithm, an artificial neural network (ANN) algorithm, a convolutional neural network (CNN) algorithm, a recurrent neural network (RNN) algorithm, a long short-term memory (LSTM) algorithm, a deep learning algorithm, a decision tree learning algorithm, a regression analysis algorithm, a Bayesian network algorithm, a genetic algorithm, a federated learning algorithm, a distributed artificial intelligence algorithm, and so forth. Embodiments are not limited in this context.

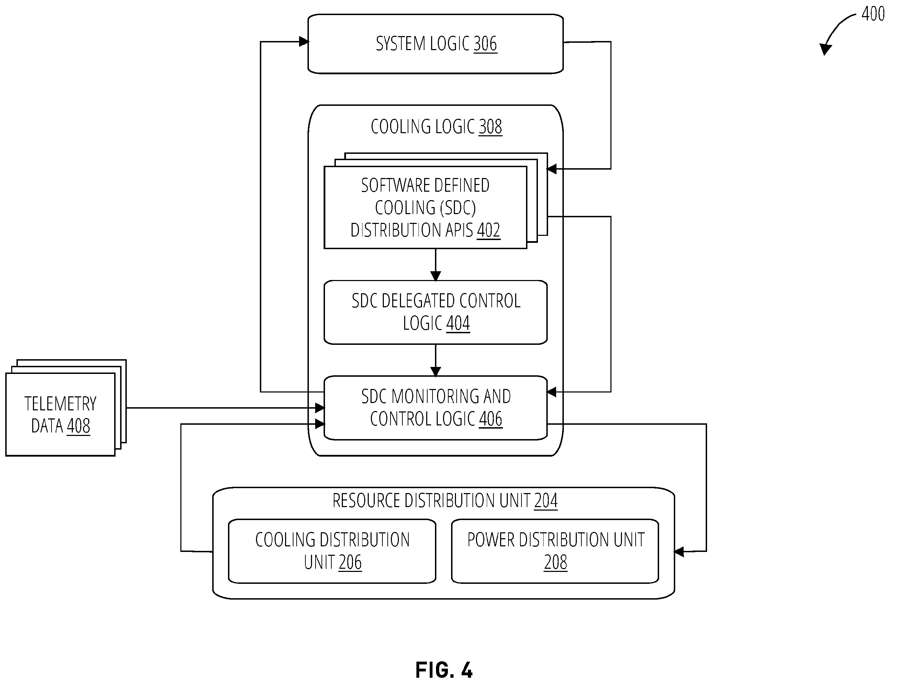

FIG. 4 illustrates a logic diagram 400 suitable for the system control circuitry 118. The logic diagram 400 comprises a more detailed architecture for the system control circuitry 118 to control or manage the cooling system 100 and the cooling system 200.

As depicted in FIG. 4, the system logic 306 communicates with the cooling logic 308 and the resource distribution unit 204. The system logic 306 implements, for example, orchestration policy logic that implements one or more orchestration policies for the cooling system 100 and cooling system 200. An orchestration policy comprises a set of rules or guidelines designed to manage and coordinate the configuration, provision, and deployment of resources and services across a distributed environment, such as cloud compute data center environment or an edge computing environment. These policies enable automated decisionmaking regarding where, when, and how computing tasks are executed within the distributed framework of an edge network, considering factors like resource availability, network conditions, application requirements, and security constraints.

The cooling logic 308 implements a set of SDC distribution APIs 402, an SDC delegated control logic 404, and SDC monitoring and control logic 406. The system logic 306 interacts with the SDC distribution APIs 402 of the cooling logic 308. The SDC distribution APIs 402 are interfaces to access and control the cooling logic 308 for the cooling system 100 and cooling system 200. The system logic 306 accesses the SDC delegated control logic 404 via the SDC distribution APIs 402. The SDC delegated control logic 404 represents a binary or bit-stream, such as a software application, that has access to the ML models 316 that provide insights on how the cooling system 100 and the cooling system 200 are expected to behave in response to changes and also decisions on how to setup the overall cooling topology for the SDC structures 120. The SDC delegated control logic 404 sends commands to the SDC monitoring and control logic 406. The SDC monitoring and control logic 406 is responsible for monitoring or configuring the various topologies that are either provided via the SDC distribution APIs 402 or the SDC delegated control logic 404. The SDC monitoring and control logic 406 is also responsible for receiving telemetry data 408 from the sensors 236, and it sends commands to the cooling distribution unit 206 and the power distribution unit 208 of the resource distribution unit 204. The resource distribution unit 204 provides feedback information to the SDC monitoring and control logic 406.

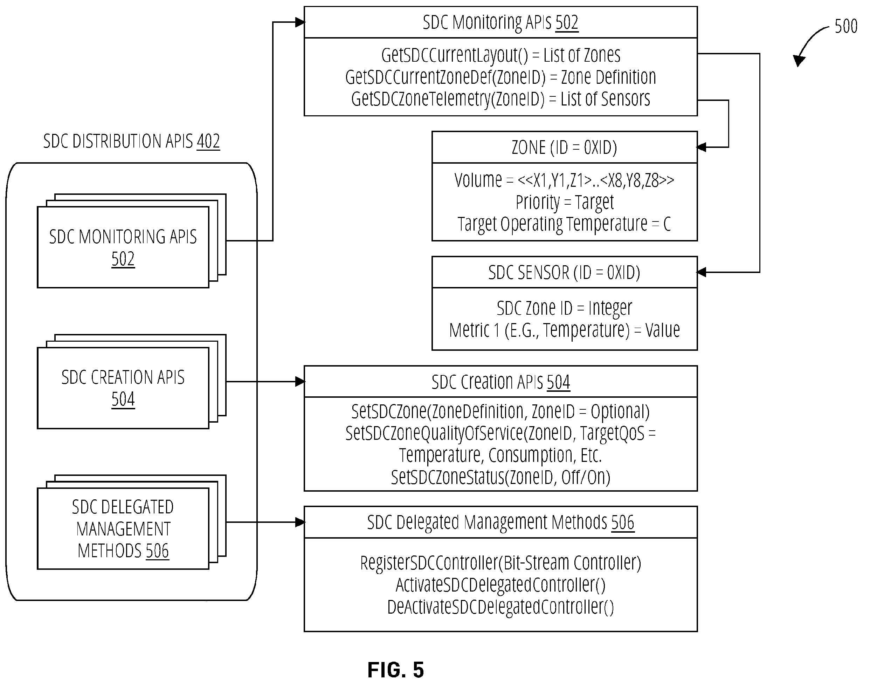

FIG. 5 illustrates a logic diagram 500. The logic diagram 500 comprises an example implementation for the SDC distribution APIs 402 of the cooling logic 308.

The SDC distribution APIs 402 may comprise different types of APIs. For example, the SDC distribution APIs 402 may include one or more SDC monitoring APIs 502 to receive or retrieve a layout for the cooling zone 228, configuration data for the cooling zones 228, and telemetry data 408 for the cooling zones 228. Examples of SDC monitoring APIs 502 may include GetSDCCurrentLayout() = list of zones, GetSDCCurrentZoneDef(ZoneID) = Zone definition, GetSDCZoneTelemetry(ZoneID) = List of Sensors, and so forth. Examples of zone definitions may include Volume = <<x1,y1,z1>..<x8,y8,z8>>, Priority = Target, Target Operating Temperature = C, and so forth. Examples of SDC sensors may include SDC Zone ID = Integer, Metric 1 (e.g., Temperature) = Value, and so forth.

The SDC distribution APIs 402 may comprise one or more SDC creation APIs 504 to create and update configuration data representing a setup and topology for the cooling zones 228. For example, the configuration data may include information about a volumetric area for a cooling zone 228, an SLA defining an operating target (e.g., a cooling target) for the cooling zone 228, and a priority assigned to the cooling zone 228. The system logic 306 and/or the cooling logic 308 may use the priority for the cooling zone 228 to arbitrate distribution of cooling resources and power resources when there is insufficient resources for all the cooling zones 228. Examples of SDC creation APIs 504 may include SetSDCZone(ZoneDefinition, ZoneID = optional), SetSDCZoneQualityOfService(ZoneID, TargetQoS = Temperature, consumption, etc., SetSDCZoneStatus(ZoneID, Off/On), and so forth.

The SDC distribution APIs 402 may comprise one or more SDC delegated management methods 506. Examples for SDC delegated management methods 506 may include RegisterSDCController(bit-stream Controller), ActivateSDCDelegatedController(), DeActivateSDCDelegatedController(), and so forth.

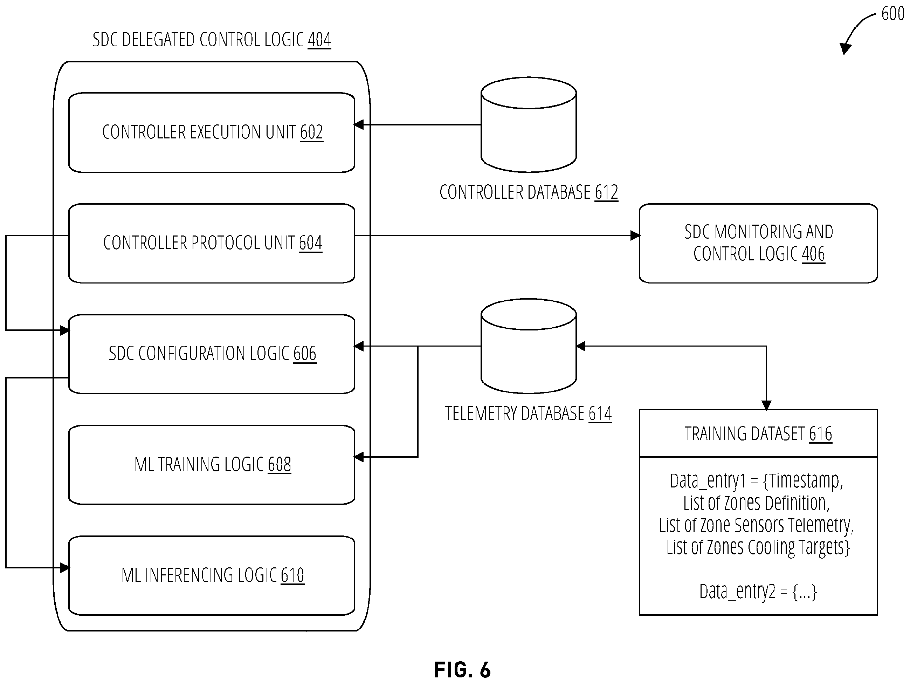

FIG. 6 illustrates a logic diagram 600. The logic diagram 600 is an example implementation for the SDC delegated control logic 404 of the cooling logic 308.

As depicted in FIG. 6, the SDC delegated control logic 404 comprises a controller execution unit 602, a controller protocol unit 604, an SDC configuration logic 606, an ML training logic 608, and an ML inferencing logic 610. The server device 102 and/or the server device 142 has a controller execution unit 602 (e.g., processing circuitry 302) to execute the SDC delegated control logic 404. The controller execution unit 602 has access to interfaces to access data stored by the controller database 612. For example, the controller execution unit 602 has access to interfaces to access the telemetry data 408 of different cooling zones 228, interfaces to setup different cooling zones 228, and interfaces to access the ML inferencing logic 610. The controller protocol unit 604 governs the operations of certain subsystems or manages interactions between complex parts of the server device 102 according a one or more protocols. The controller protocol unit 604 is responsible for implementing communication standards to manage, direct, or facilitate data exchanges between different parts of the cooling system 100 and cooling system 200. The SDC configuration logic 606 evaluates changes on potential configurations of the layout of the cooling zones 228, the positions 218, and/or the SDC structures 120 using the ML inferencing logic 610.

The ML training logic 608 may train an ML model 316 using a training dataset 616 for use by the ML inferencing logic 610. The SDC delegated control logic 404 may collect and process telemetry data 408 from the different cooling zones 228 to form the training dataset 616. A telemetry database 614 may store the training dataset 616. For example, the training dataset 616 may comprise multiple datapoints. An example of a datapoint may comprise: data_entry1 = {timestamp, list of zones definition, list of zone sensors telemetry, list of zones cooling targets}, data_entry2 = {...}, and so forth. The ML training logic 608 may access the training dataset 616 from the telemetry database 614 to train the ML model 316. The trained ML model 316 is deployed to the server device 102 and/or the server device 142 for access by the SDC configuration logic 606.

The ML inferencing logic 610 may receive various types of inputs. For example, the ML inferencing logic 610 may receive as input current telemetry data 408 for one or more cooling zones 228 and required SLAs associated with the one or more cooling zones 228. Further, the ML inferencing logic 610 may receive as input current configuration data of the SDC structures 120 relative to the cooling zones 228. The ML inferencing logic 610 may analyzes the different inputs, and generate various outputs. For example, the ML inferencing logic 610 may generate different configuration data for the cooling zones 228, an amount of cooling required for each cooling zone 228, and so forth. The ML training logic 608 may update the ML model 316 when new telemetry data 408 is added to the training dataset 616, retrain the ML model 316 with the new training dataset 616, and deploy the re-trained ML model 316 to support the ML inferencing logic 610.

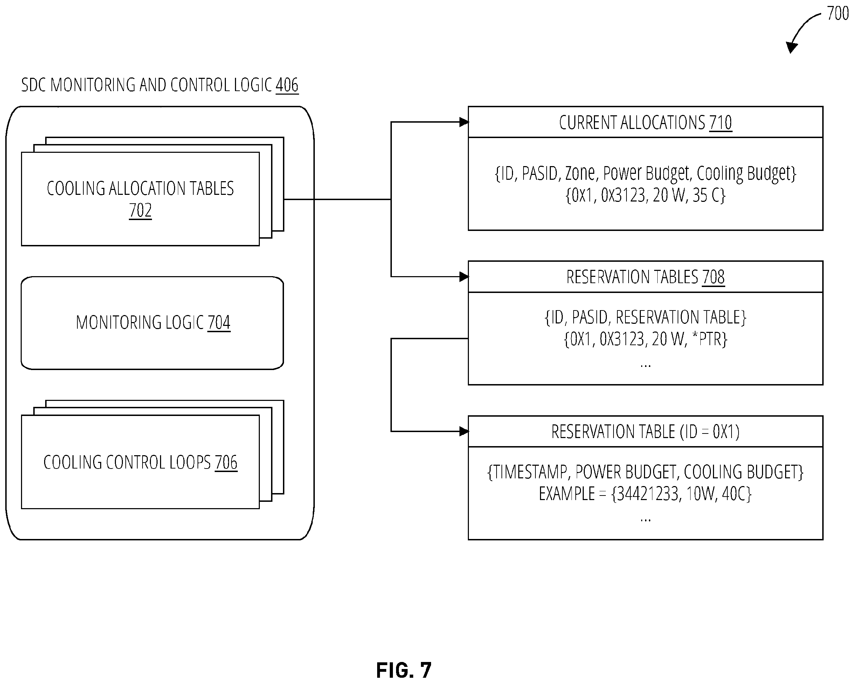

FIG. 7 illustrates a logic diagram 700. The logic diagram 700 is an example implementation for the SDC monitoring and control logic 406 of the cooling logic 308. The SDC monitoring and control logic 406 is responsible for configuring the cooling zones 228 over time depending on configuration data provided by the system logic 306 (e.g., orchestration logic) or by the delegated configuration.

As depicted in FIG. 7, the SDC monitoring and control logic 406 comprises a set of cooling allocation tables 702, a monitoring logic 704, and a set of cooling control loops 706. The cooling allocation tables 702 are data structures comprising information such as current allocations 710 and reservation tables 708. Examples for current allocations 710 comprise information such as {ID, PASID, Zone, Power Budget, Cooling Budget}, {0x1, 0x3123, 20 W, 35 C}, and so forth. Examples for reservation tables 708 comprise information such as {ID, PASID, Reservation Table}, {0x1, 0x3123, 20 W, *Ptr}, and so forth, or information for multiple reservation tables 708 such as Reservation Table (ID = 0x1), {TimeStamp, Power Budget, Cooling Budget}, Example = {34421233, 10W, 40C}, Reservation Table (ID = 0x2){...}, and so forth.

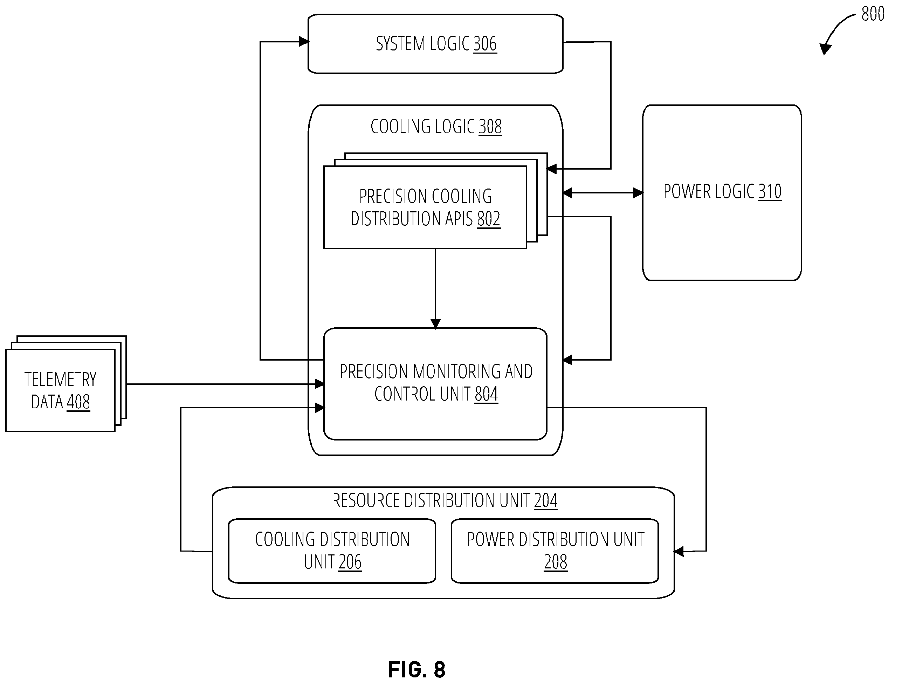

FIG. 8 illustrates a logic diagram 800. The logic diagram 800 comprises a more detailed architecture for the system control circuitry 118 to control or manage the cooling system 100 and the cooling system 200.

The logic diagram 800 illustrates an example architecture for implementing a dynamic cooling solution that can adapt to different operational phases of software and hardware of the server device 102 in accordance with various embodiments as described herein. As compute demands continue to grow, especially with the increasing prevalence of accelerators and GPUs for generative AI solutions, thermal constraints emerge as a significant bottleneck for system and server rack design. This in turn, has placed a sharp emphasis on cooling solutions to manage this power consumption. In current data centers, all the cooling systems act as independent entities that operate cooling mechanisms to maintain a certain temperature target. However, workloads and use cases do not always require a constant energy efficiency or performance. Therefore, cooling requirements for a system will change over time, depending on factors such as the phases of the workload, overall load on the system, priority levels, SLAs, SLOs, and other considerations. Further, system resources consumed by the varying workloads may also change over time. For example, ML models such as LLMs operate in two phases. The first phase is a time to first token. The second phase is an average time for a remainder of the tokens. Unlike the first phase, the second phase is completely memory bandwidth bound, and exercises significant power (and thermal stress) on the memory subsystem. However, this phenomena is not observed in the first phase.

The system logic 306 and the cooling logic 308 of the system control circuitry 118 operate in combination to recognize when workload resource requirements for the electronic components 110 change over time. The system logic 306 and cooling logic 308 control the SDC structures 120 to perform precision cooling that is co-orchestrated with software and hardware system requirements of the server device 102. For example, the cooling logic 308 implements a set of precision cooling distribution APIs 802 to adapt cooling per cooling zones 228 depending on cooling policies associated with the cooling zone 228, such as defined by SLAs and/or SLOs. The system logic 306 and the cooling logic 308 use the precision cooling distribution APIs 802 to configure or adapt the cooling zones 228 co-orchestrated with software and hardware system requirements of the server device 102. Further, the system logic 306 and the cooling logic 308 use the precision cooling distribution APIs 802 and a precision monitoring and control unit 804 to distribute cooling and power delivery across the cooling zones 228.

The cooling logic 308 comprises a set of precision cooling distribution APIs 802 and a precision monitoring and control unit 804. The precision cooling distribution APIs 802 are a set of APIs and interfaces to implement precise control of cooling and power delivery via the cooling distribution unit 206 and the power distribution unit 208, respectively. The precision monitoring and control unit 804 controls distribution of cooling resources and power resources adaptively depending on a set of SLA and/or SLO requirements for the server device 102. The precision monitoring and control unit 804 includes monitoring capabilities that can be used by the software stack or control loop features to make real-time decisions to control the cooling distribution unit 206 to distribute the cooling fluid 132 from the fluid reservoir 130 to the SDC structures 120. Similarly, the cooling logic 308 may coordinate with the power logic 310 to use the monitoring capabilities to make real-time decisions to control the power distribution unit 208 to distribute power from the power supply 106 to the SDC structures 120 and/or the electronic components 110. In either or both cases, the system logic 306 coordinates decisions of the cooling logic 308 and/or the power logic 310 using system-level policies, such as orchestration policies for a larger system implementing the server device 102, such as a server rack, cloud compute data center, or edge system data center.

The system logic 306, the cooling logic 308, and/pr the power logic 310 adaptively distribute, control, and deliver power and cooling across different electronic components 110 of the server device 102. The precision monitoring and control unit 804 collects telemetry data 408 from the sensors 236 associated with electronic components 110, and analyzes the telemetry data 408 to generate a set of metrics, such as XPU metrics like floating point operations (FLOPS) or clocks per instruction. The system logic 306, the cooling logic 308, and/or the power logic 310 use this information to implement a closed loop power and liquid cooling intelligent infrastructure. For example, the precision monitoring and control unit 804 may implement a definition such as X FLOPS at Y Watts requires Z degrees C water or immersion liquid, with an incremental increase equation identified and maintained by the system logic 306, on a per-component basis within the server device 102 inserted into a server chassis or server rack. The system logic 306 may use these and other definitions to adaptively distribute cooling and power resources to the SDC structures 120 and/or the electronic components 110. Embodiments are not limited to these examples.

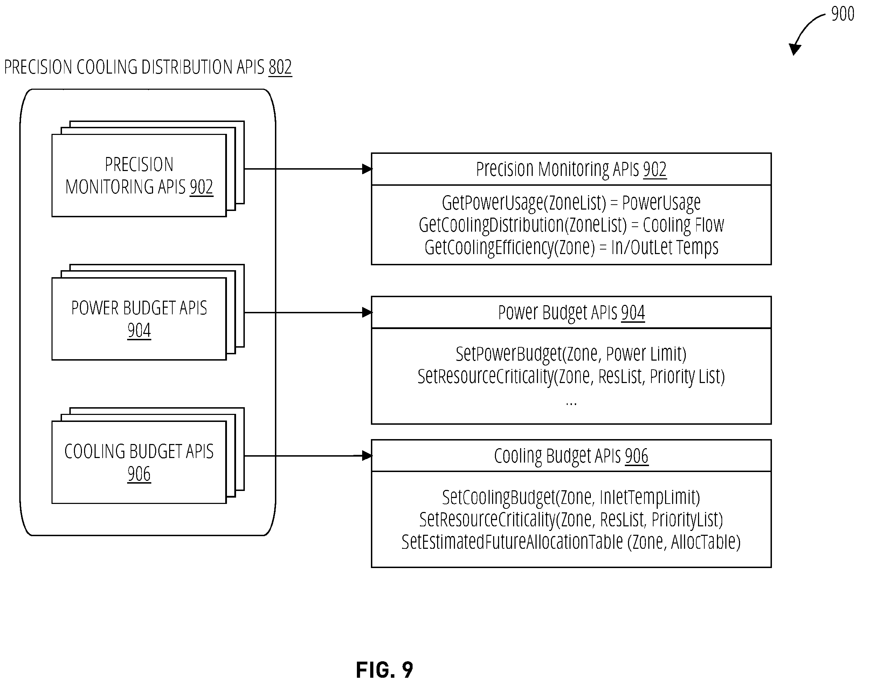

FIG. 9 illustrates a logic diagram 900. The logic diagram 900 comprises a more detailed architecture for the precision cooling distribution APIs 802 of the cooling logic 308 of the system control circuitry 118 to control or manage the cooling system 100 and the cooling system 200.

As depicted in FIG. 9, the precision cooling distribution APIs 802 comprises a set of precision monitoring APIs 902, a set of power budget APIs 904, and a set of cooling budget APIs 906. The precision monitoring APIs 902 are used to get telemetry data 408 from the sensors 236, such as power, cooling, and cooling efficiency per cooling zone 228 in the device chassis 104. For example, the precision monitoring APIs 902 may comprise defined APIs such as GetPowerUsage(ZoneList) = PowerUsage, GetCoolingDistribution(ZoneList) = Cooling Flow, GetCoolingEfficiency(Zone) = In/OutLet Temps, and so forth. The power budget APIs 904 are used to set power budgets and criticality for each of the cooling zones 228 in the device chassis 104. For example, the power budget APIs 904 may comprise defined APIs such as SetPowerBudget(Zone, Power Limit), SetResourceCriticality(Zone, ResList, Priority List), and so forth. The cooling budget APIs 906 are used to set cooling and estimated future requirement allocations. For example, the cooling budget APIs 906 may comprise defined APIs such as SetCoolingBudget(Zone, InletTempLimit), SetResourceCriticality(Zone, ResList, PriorityList), SetEstimatedFutureAllocationTable (Zone, AllocTable), and so forth. Embodiments are not limited to these examples.

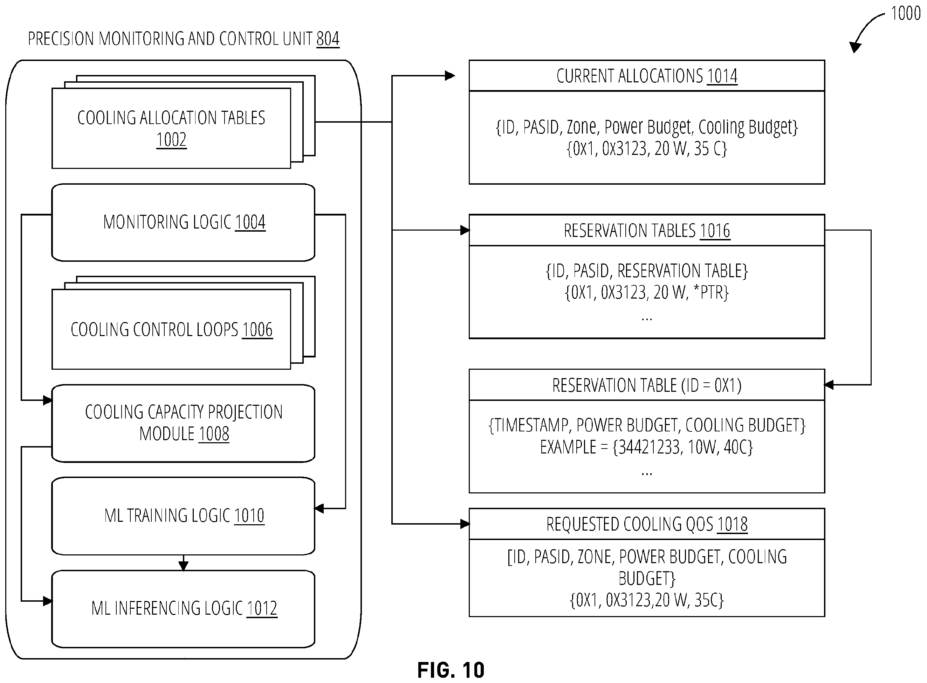

FIG. 10 illustrates a logic diagram 1000. The logic diagram 1000 comprises a more detailed architecture for the precision monitoring and control unit 804 of the cooling logic 308 of the system control circuitry 118 to control or manage the cooling system 100 and the cooling system 200.

The precision monitoring and control unit 804 is responsible for maintaining the SLOs of the cooling zones 228 based on the SLAs associated with the cooling zones 228. As depicted in FIG. 10, the precision monitoring and control unit 804 comprises a set of cooling allocation tables 1002, a monitoring logic 1004, a set of cooling control loops 1006, a cooling capacity projection module 1008, an ML training logic 1010, and an ML inferencing logic 1012.

The precision monitoring and control unit 804 implements a set of cooling allocation tables 1002. The cooling allocation tables 1002 are data structures comprising information such as current allocations 1014 and reservation tables 1016. The current allocations 1014 include definitions for each cooling zone 228 and an amount required by the SLAs. For example, a cooling zone 228 may be defined by a zone identifier (ID), a process ID (PASID), a power budget, and a cooling budget. Examples for current allocations 1014 comprise information such as {ID, PASID, Zone, Power Budget, Cooling Budget}, {0x1, 0x3123, 20 W, 35 C}, and so forth. The reservation tables 1016 are associated with a particular PASID and define a future resource allocations, such as an estimated allocation, timestamp, and other information. Examples for reservation tables 1016 comprise information such as {ID, PASID, Reservation Table}, {0x1, 0x3123, 20 W, *Ptr}, and so forth, or information for multiple reservation tables 1016 such as Reservation Table (ID = 0x1), {TimeStamp, Power Budget, Cooling Budget}, Example = {34421233, 10W, 40C}, Reservation Table (ID = 0x2){...}, and so forth. Further, the cooling allocation tables 1002 may include data structures comprising information such as requested cooling QoS 1018. Examples for the requested cooling QoS 1018 may include [ID, PASID, Zone, Power Budget, Cooling Budget}, {0x1, 0x3123,20 W, 35C}, and so forth.

The precision monitoring and control unit 804 comprises a cooling capacity projection module 1008. The cooling capacity projection module 1008 is responsible for filling in definitions for the reservation tables 1016. For example, the cooling capacity projection module 1008 may implement an ML training logic 1010 to train an ML model 316 to deploy as ML inferencing logic 1012. The ML inferencing logic 1012 receives as input a current set of reservation tables 1016 for the cooling zones 228, analyzes the reservation tables 1016, and generates as output an amount of cooling and power distribution needed to meet a next set of reservation tables 1016 for the cooling zone 228. For example, the ML training logic 1010 may implement a reinforcement learning (RL) algorithm to train the ML model 316 for the ML inferencing logic 1012.

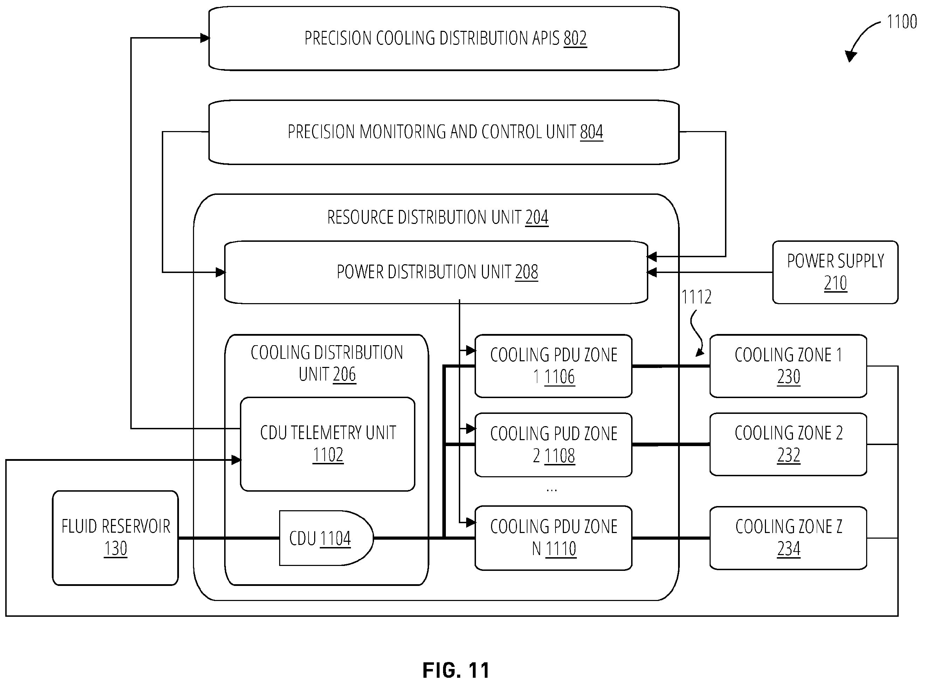

FIG. 11 illustrates a logic diagram 1100. The logic diagram 1100 comprises a more detailed architecture for the precision monitoring and control unit 804 of the cooling logic 308 of the system control circuitry 118 to control or manage the resource distribution unit 204 of the cooling system 200.

As depicted in FIG. 11, the resource distribution unit 204 comprises the cooling distribution unit 206 and the power distribution unit 208. The cooling distribution unit 206 distributes the cooling fluid 132 from the fluid reservoir 130 in response to control directives from the system logic 306 and/or the cooling logic 308 via the precision cooling distribution APIs 802. The power distribution unit 208 distributes power provided by the power supply 210 in response to control directives from the precision monitoring and control unit 804.

The cooling distribution unit 206 includes a CDU telemetry unit 1102 to monitor sensor data from the sensors 236 for the cooling zones 228, such as cooling zone 1 230, cooling zone 2 232, and cooling zone Z 234. The CDU telemetry unit 1102 generates telemetry data 408 for delivery to the system logic 306 and/or the cooling logic 308 via the precision cooling distribution APIs 802. Different cooling zones 228 may implement different cooling solutions that need different types of sensors 236. As such, the CDU telemetry unit 1102 is designed to receive as input as many different types of sensor data as there are sensors 236 implemented for the cooling zones 228.

The system logic 306 and/or the cooling logic 308 generates a control directive 138 to increase or decrease cooling for one or more electronic components 110 in one or more cooling zones 228 via one or more SDC structures 120. The SDC structures 120 may implement infrastructure equipment depending upon a particular cooling technology implemented for the SDC structures 120. For example, when an SDC structure 120 implements an air cooling solution, the air pipes are inserted throughout the server device 102, including the cooling rail track 122 and the SDC structure 120. Different SDC structures 120 may implement different cooling solutions, with the appropriate delivery channels for each cooling solution. In another example, when an SDC structure 120 implements a liquid cooling solution, such as cooling system 200, fluid pipes are inserted throughout the server device 102, including the cooling rail track 122 and the SDC structure 120. The cooling distribution unit 206 is configured to distribute different types of cooling based on the cooling technologies implemented for each of the cooling zones 228. For example, in the liquid cooling solution of the cooling system 200, the cooling distribution unit 206 implements a coolant distribution unit 1104 with fluid pipes 128 to distributed the cooling fluid 132 from the fluid reservoir 130 to the SDC structures 120 for the cooling zone 1 230, cooling zone 2 232, and cooling zone Z 234 via local cooling distribution units, such as cooling PDU zone 1 1106, cooling PUD zone 2 1108, and cooling PDU zone N 1110, respectively, where N represents any positive integer.

Similarly, the system logic 306 and/or the power logic 310 generates a control directive 138 to increase or decrease power for one or more electronic components 110 in one or more cooling zones 228, or power to one or more SDC structures 120 in one or more cooling zones 228. For example, power may be dynamically increased to obtain an increase in cooling capabilities of an SDC structure 120 or dynamically decreased to obtain a decrease in cooling capabilities of the SDC structure 120 in response to thermals generated from increased or decreased workloads for an electronic component 110. For example, power may be dynamically increased to obtain an increase in computing capabilities of an electronic component 110 when a cooling capacity of an SDC structure 120 allows a greater amount of heat reduction, or dynamically decreased to obtain a decrease in computing capabilities of the electronic component 110 when the cooling capacity of the SDC structure 120 is at its cooling limits or the electronic component 110 is reaching a DTR limit.

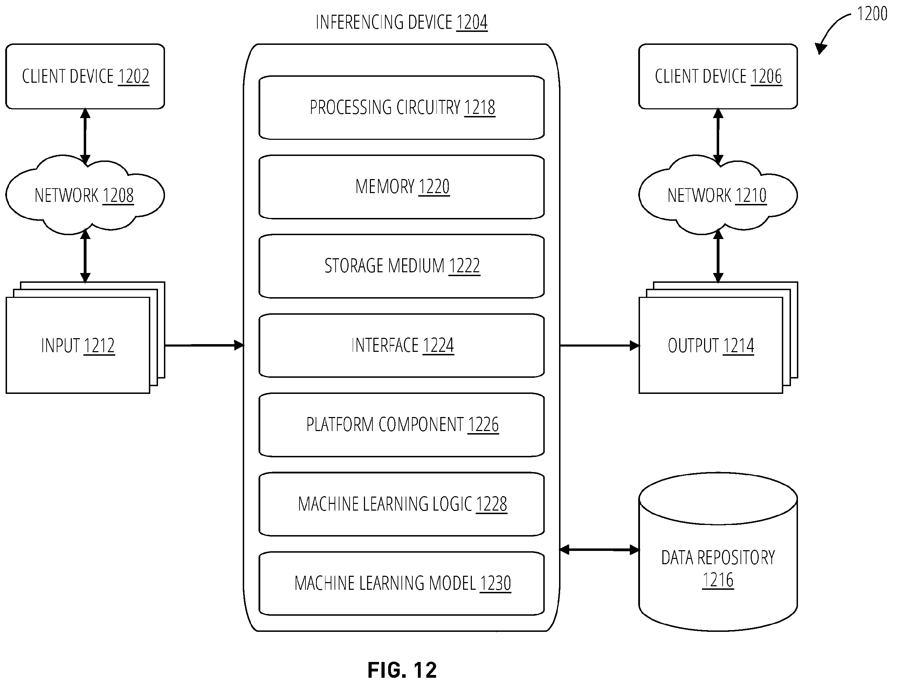

FIG. 12 illustrates an embodiment of a system 1200. The system 1200 is suitable for implementing one or more embodiments as described herein. In one embodiment, for example, the system 1200 is an AI/ML system suitable for supporting AI/ML techniques implemented for the cooling system 100 and the cooling system 200, such as the ML algorithms 314, the ML models 316, the ML training logic 608, the ML inferencing logic 610, the ML training logic 1010, the ML inferencing logic 1012, and so forth.

The system 1200 comprises a set of *M* devices, where *M* is any positive integer. FIG. 12 depicts three devices (M=3), including a client device 1202, an inferencing device 1204, and a client device 1206. The inferencing device 1204 communicates information with the client device 1202 and the client device 1206 over a network 1208 and a network 1210, respectively. The information may include input 1212 from the client device 1202 and output 1214 to the client device 1206, or vice-versa. In one alternative, the input 1212 and the output 1214 are communicated between the same client device 1202 or client device 1206. In another alternative, the input 1212 and the output 1214 are stored in a data repository 1216. In yet another alternative, the input 1212 and the output 1214 are communicated via a platform component 1226 of the inferencing device 1204, such as an input/output (I/O) device (e.g., a touchscreen, a microphone, a speaker, etc.).

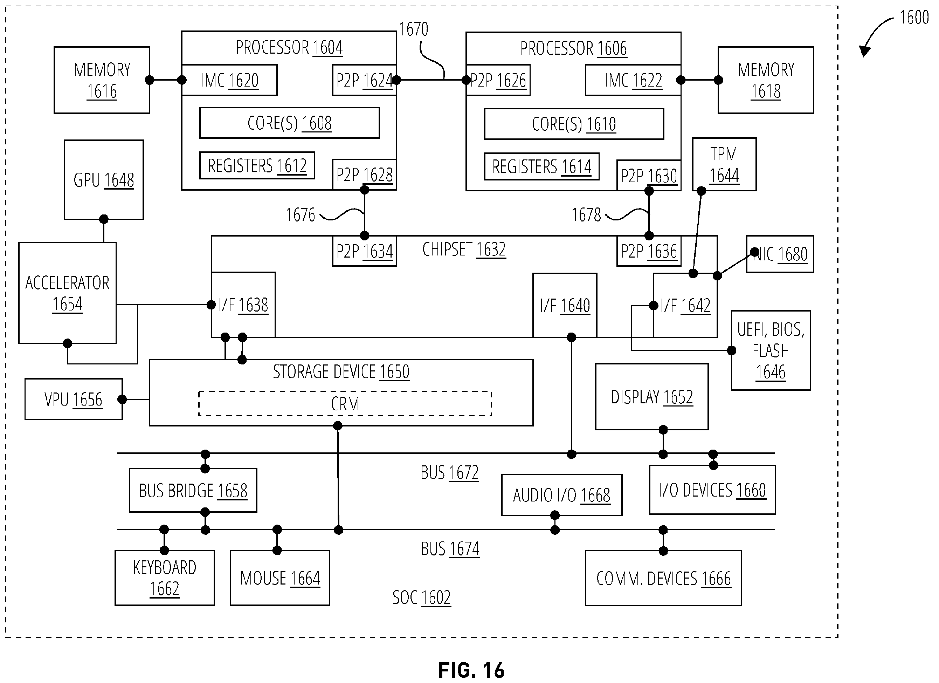

As depicted in FIG. 12, the inferencing device 1204 includes processing circuitry 1218, a memory 1220, a storage medium 1222, an interface 1224, a platform component 1226, ML logic 1228, and an ML model 1230. In some implementations, the inferencing device 1204 includes other components or devices as well. Examples for software elements and hardware elements of the inferencing device 1204 are described in more detail with reference to a computing architecture 1600 as depicted in FIG. 16. Embodiments are not limited to these examples.

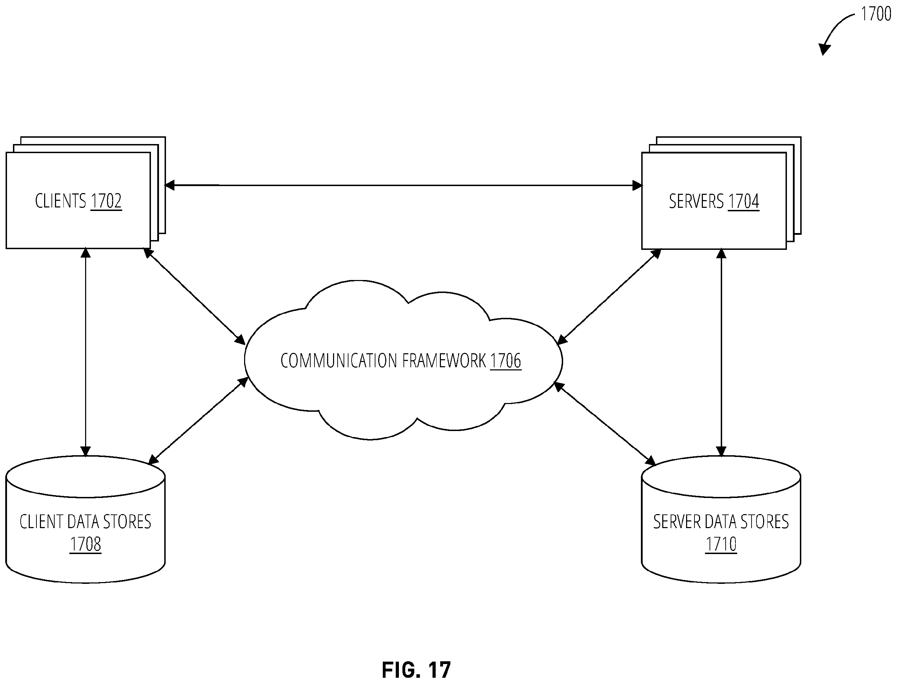

The inferencing device 1204 is generally arranged to receive an input 1212, process the input 1212 via one or more AI/ML techniques, and send an output 1214. The inferencing device 1204 receives the input 1212 from the client device 1202 via the network 1208, the client device 1206 via the network 1210, the platform component 1226 (e.g., a touchscreen as a text command or microphone as a voice command), the memory 1220, the storage medium 1222 or the data repository 1216. The inferencing device 1204 sends the output 1214 to the client device 1202 via the network 1208, the client device 1206 via the network 1210, the platform component 1226 (e.g., a touchscreen to present text, graphic or video information or speaker to reproduce audio information), the memory 1220, the storage medium 1222 or the data repository 1216. Examples for the software elements and hardware elements of the network 1208 and the network 1210 are described in more detail with reference to a communications architecture 1700 as depicted in FIG. 17. Embodiments are not limited to these examples.

The inferencing device 1204 includes ML logic 1228 and an ML model 1230 to implement various AI/ML techniques for various AI/ML tasks. The ML logic 1228 receives the input 1212, and processes the input 1212 using the ML model 1230. The ML model 1230 performs inferencing operations to generate an inference for a specific task from the input 1212. In some cases, the inference is part of the output 1214. The output 1214 is used by the client device 1202, the inferencing device 1204, or the client device 1206 to perform subsequent actions in response to the output 1214.

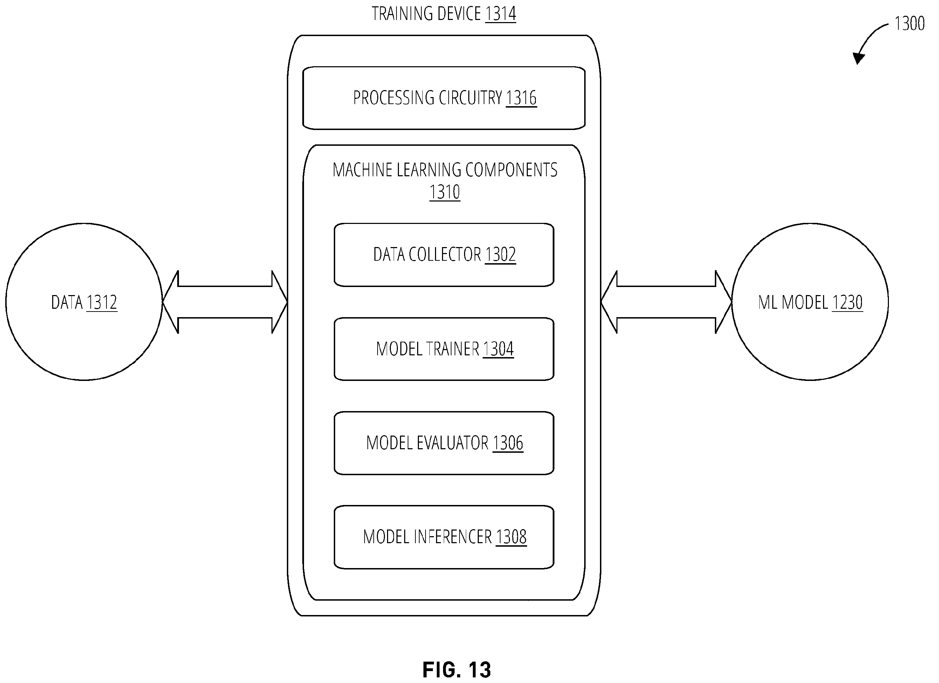

In various embodiments, the ML model 1230 is a trained ML model 1230 using a set of training operations. An example of training operations to train the ML model 1230 is described with reference to FIG. 13.

FIG. 13 illustrates an apparatus 1300. The apparatus 1300 depicts a training device 1314 suitable to generate a trained ML model 1230 for the inferencing device 1204 of the system 1200. As depicted in FIG. 13, the training device 1314 includes a processing circuitry 1316 and a set of ML components 1310 to support various AI/ML techniques, such as a data collector 1302, a model trainer 1304, a model evaluator 1306 and a model inferencer 1308.

In general, the data collector 1302 collects data 1312 from one or more data sources to use as training data for the ML model 1230. The data collector 1302 collects different types of data 1312, such as text information, audio information, image information, video information, graphic information, and so forth. The model trainer 1304 receives as input the collected data and uses a portion of the collected data as test data for an AI/ML algorithm to train the ML model 1230. The model evaluator 1306 evaluates and improves the trained ML model 1230 using a portion of the collected data as test data to test the ML model 1230. The model evaluator 1306 also uses feedback information from the deployed ML model 1230. The model inferencer 1308 implements the trained ML model 1230 to receive as input new unseen data, generate one or more inferences on the new data, and output a result such as an alert, a recommendation or other post-solution activity.

Operations for the disclosed embodiments are further described with reference to the following figures. Some of the figures include a logic flow. Although such figures presented herein include a particular logic flow, the logic flow merely provides an example of how the general functionality as described herein is implemented. Further, a given logic flow does not necessarily have to be executed in the order presented unless otherwise indicated. Moreover, not all acts illustrated in a logic flow are required in some embodiments. In addition, the given logic flow is implemented by a hardware element, a software element executed by one or more processing devices, or any combination thereof. The embodiments are not limited in this context.

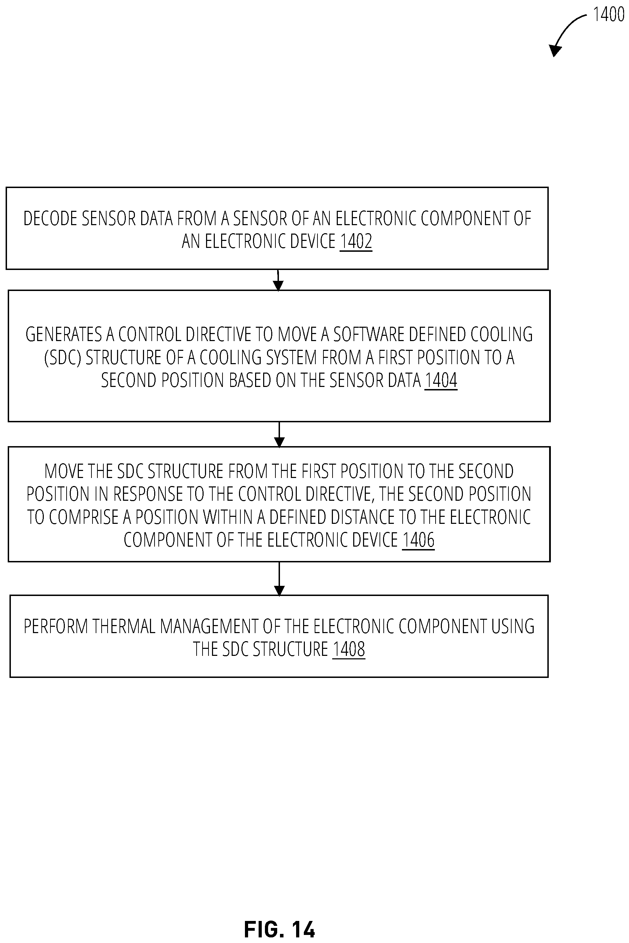

FIG. 14 illustrates an embodiment of a logic flow 1400. The logic flow 1400 is representative of some or all of the operations executed by one or more embodiments described herein. For example, the logic flow 1400 includes some or all of the operations performed by devices or entities within the cooling system 100, the cooling system 200, the apparatus 300, the logic diagram 400, the logic diagram 500, the logic diagram 600, the logic diagram 700, the logic diagram 800, the logic diagram 900, the logic diagram 1000, the logic diagram 1100, the system 1200, or the apparatus 1300. In one embodiment, the logic flow 1400 is implemented as instructions stored on a non-transitory computer-readable storage medium, such as the storage medium 1222, that when executed by the processing circuitry 1218 causes the processing circuitry 1218 to perform the described operations. The storage medium 1222 and processing circuitry 1218 may be co-located, or the instructions may be stored remotely from the processing circuitry 1218. Collectively, the storage medium 1222 and the processing circuitry 1218 may form a system.

In block 1402, the logic flow 1400 performs decoding sensor data from a sensor of an electronic component of an electronic device. In block 1404, the logic flow 1400 performs generating a control directive to move a software defined cooling (SDC) structure of a cooling system from a first position to a second position based on the sensor data. In block 1406, the logic flow 1400 performs moving the SDC structure from the first position to the second position in response to the control directive, the second position to comprise a position within a defined distance to the electronic component of the electronic device. In block 1408, the logic flow 1400 performs thermal management of the electronic component using the SDC structure.

By way of example, a computing apparatus includes a memory unit 202 operably coupled to system control circuitry 118. The system control circuitry 118 performs operations, such as cooling operations to decode sensor data from a sensor 236 of an electronic component 110 of an electronic device, such as server device 102. The system control circuitry 118 generates a control directive 138 to move an SDC structure 120 of a cooling system 100 or a cooling system 200 from a first position 1 220 to a second position 2 222 based on the sensor data. The system control circuitry 118 causes the cooling rail track 122 to move the SDC structure 120 from the first position 1 220 to the second position 2 222 in response to the control directive 138, where the second position 2 222 to comprise a position within a defined distance to the electronic component 110 of the server device 102. The system control circuitry 118 initiates thermal management of the electronic component 110 using the SDC structure 120. For example, the first position 1 220 and the second position 2 222 represent numerical coordinates in a 3D coordinate system, such as a Cartesian coordinate system. For example, the position 1 220 and the second position 2 222 are located in different cooling zones 228. For example, the first position 1 220 is located in a first cooling zone 1 230 and the second position 2 222 is located in a second cooling zone 2 232.

In one embodiment, for example, the system control circuitry 118 is arranged to access configuration data for a cooling zone 228 where the electronic component 110 is located, where the configuration data includes a volumetric area for the cooling zone 228, an SLA or an SLO defining an operating target for the cooling zone 228, a priority level associated with the cooling zone 228, or reservation data for the cooling zone 228.

In one embodiment, for example, the system control circuitry 118 is arranged to decode sensor data from a sensor 236 that the SDC structure 120 is located at the second position 2 222, and generate a control directive 138 to initiate cooling operations of the SDC structure 120 to reduce a temperature of the electronic component 110 by the SDC structure 120. For example, the system control circuitry 118 is arranged to generate the control directive 138 to move the SDC structure 120 of the cooling system 200 from the first position 1 220 to the second position 2 222 based on the sensor data and the volumetric area for the cooling zone 228, the SLA or SLO for the cooling zone 228, the priority level associated with the cooling zone 228, or the reservation data for the cooling zone 228.

Various embodiments utilize an ML algorithm 314 to train an ML model 316 to predict workloads for the electronic components 110, configure or re-configure the cooling zones 228, generate cooling and/or power requirements for the cooling zones 228, and perform other downstream tasks. In one embodiment, for example, the system control circuitry 118 is arranged to receive as input the configuration data for the cooling zone 228 by an ML model 316 for a first defined time interval, and generate an amount of cooling the SDC structure 120 delivers for the cooling zone 228 within the first defined time interval by the ML model 316 based on the configuration data. In one embodiment, for example, the system control circuitry 118 is arranged to receive as input the reservation data from reservation tables 708 and/or reservation tables 1016 for the cooling zone 228 by the ML model 316 for a first defined time interval and a second defined time interval, generate an amount of cooling the SDC structure 120 delivers for the cooling zone 228 within the first defined time interval and the second defined time interval by the ML model 316 based on the reservation data.

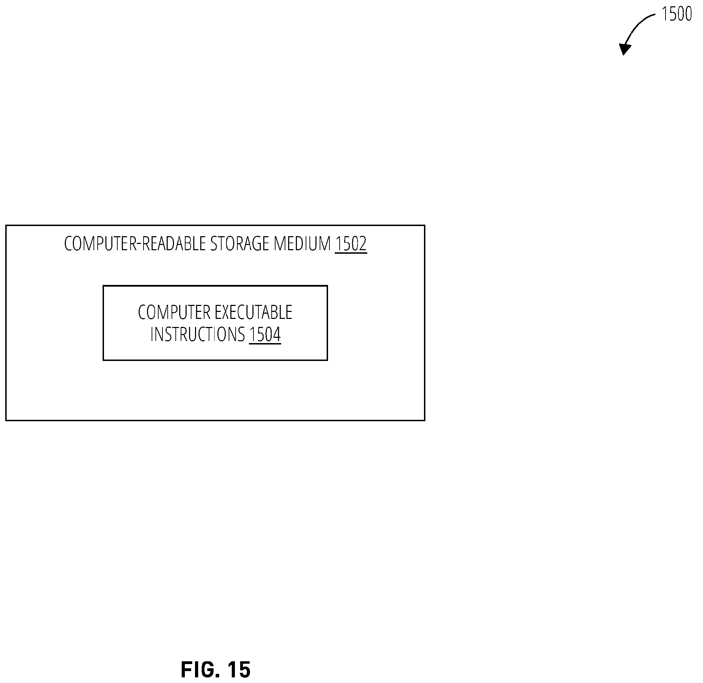

FIG. 15 illustrates an apparatus 1500. Apparatus 1500 comprises any non-transitory computer-readable storage medium 1502 or machine-readable storage medium, such as an optical, magnetic or semiconductor storage medium. In various embodiments, apparatus 1500 comprises an article of manufacture or a product. In some embodiments, the computer-readable storage medium 1502 stores computer executable instructions with which one or more processing devices or processing circuitry can execute. For example, computer executable instructions 1504 includes instructions to implement operations described with respect to any logic flows described herein. Examples of computer-readable storage medium 1502 or machine-readable storage medium include any tangible media capable of storing electronic data, including volatile memory or non-volatile memory, removable or non-removable memory, erasable or non-erasable memory, writeable or re-writeable memory, and so forth. Examples of computer executable instructions 1504 include any suitable type of code, such as source code, compiled code, interpreted code, executable code, static code, dynamic code, object-oriented code, visual code, and the like.

FIG. 16 illustrates an embodiment of a computing architecture 1600. Computing architecture 1600 is a computer system with multiple processor cores such as a distributed computing system, supercomputer, high-performance computing system, computing cluster, mainframe computer, mini-computer, client-server system, personal computer (PC), workstation, server, portable computer, laptop computer, tablet computer, handheld device such as a personal digital assistant (PDA), or other device for processing, displaying, or transmitting information. Similar embodiments may comprise, e.g., entertainment devices such as a portable music player or a portable video player, a smart phone or other cellular phone, a telephone, a digital video camera, a digital still camera, an external storage device, or the like. Further embodiments implement larger scale server configurations. In other embodiments, the computing architecture 1600 has a single processor with one core or more than one processor. Note that the term "processor" refers to a processor with a single core or a processor package with multiple processor cores. In at least one embodiment, the computing architecture 1600 is representative of the components of the system 1200. More generally, the computing architecture 1600 is configured to implement all logic, systems, logic flows, methods, apparatuses, and functionality described herein with reference to previous figures.

As used in this application, the terms "system" and "component" and "module" are intended to refer to a computer-related entity, either hardware, a combination of hardware and software, software, or software in execution, examples of which are provided by the exemplary computing architecture 1600. For example, a component is, but is not limited to being, a process running on a processor, a processor, a hard disk drive, multiple storage drives (of optical and/or magnetic storage medium), an object, an executable, a thread of execution, a program, and/or a computer. By way of illustration, both an application running on a server and the server are a component. One or more components reside within a process and/or thread of execution, and a component is localized on one computer and/or distributed between two or more computers. Further, components are communicatively coupled to each other by various types of communications media to coordinate operations. The coordination involves the unidirectional or bi-directional exchange of information. For instance, the components communicate information in the form of signals communicated over the communications media. The information is implemented as signals allocated to various signal lines. In such allocations, each message is a signal. Further embodiments, however, alternatively employ data messages. Such data messages may be sent across various connections. Exemplary connections include parallel interfaces, serial interfaces, and bus interfaces.

As shown in FIG. 16, computing architecture 1600 comprises a system-on-chip (SoC) 1602 for mounting platform components. System-on-chip (SoC) 1602 is a point-to-point (P2P) interconnect platform that includes a first processor 1604 and a second processor 1606 coupled via a point-to-point interconnect 1670 such as an Ultra Path Interconnect (UPI). In other embodiments, the computing architecture 1600 is another bus architecture, such as a multi-drop bus. Furthermore, each of processor 1604 and processor 1606 are processor packages with multiple processor cores including core(s) 1608 and core(s) 1610, respectively. While the computing architecture 1600 is an example of a two-socket (2S) platform, other embodiments include more than two sockets or one socket. For example, some embodiments include a foursocket (4S) platform or an eight-socket (8S) platform. Each socket is a mount for a processor and may have a socket identifier. Note that the term platform refers to a motherboard with certain components mounted such as the processor 1604 and chipset 1632. Some platforms include additional components and some platforms include sockets to mount the processors and/or the chipset. Furthermore, some platforms do not have sockets (e.g. SoC, or the like). Although depicted as a SoC 1602, one or more of the components of the SoC 1602 are included in a single die package, a multi-chip module (MCM), a multi-die package, a chiplet, a bridge, and/or an interposer. Therefore, embodiments are not limited to a SoC.

The processor 1604 and processor 1606 are any commercially available processors, including without limitation an Intel^{®} Celeron^{®}, Core^{®}, Core (2) Duo^{®}, Itanium^{®}, Pentium^{®}, Xeon^{®}, and XScale^{®} processors; AMD^{®} Athlon^{®}, Duron^{®} and Opteron^{®} processors; ARM^{®} application, embedded and secure processors; IBM^{®} and Motorola^{®} DragonBall^{®} and PowerPC^{®} processors; IBM and Sony^{®} Cell processors; and similar processors. Dual microprocessors, multi-core processors, and other multi-processor architectures are also employed as the processor 1604 and/or processor 1606. Additionally, the processor 1604 need not be identical to processor 1606.

Processor 1604 includes an integrated memory controller (IMC) 1620 and point-to-point (P2P) interface 1624 and P2P interface 1628. Similarly, the processor 1606 includes an IMC 1622 as well as P2P interface 1626 and P2P interface 1630. IMC 1620 and IMC 1622 couple the processor 1604 and processor 1606, respectively, to respective memories (e.g., memory 1616 and memory 1618). Memory 1616 and memory 1618 are portions of the main memory (e.g., a dynamic random-access memory (DRAM)) for the platform such as double data rate type 4 (DDR4) or type 5 (DDR5) synchronous DRAM (SDRAM). In the present embodiment, the memory 1616 and the memory 1618 locally attach to the respective processors (i.e., processor 1604 and processor 1606). In other embodiments, the main memory couple with the processors via a bus and shared memory hub. Processor 1604 includes registers 1612 and processor 1606 includes registers 1614.

Computing architecture 1600 includes chipset 1632 coupled to processor 1604 and processor 1606. Furthermore, chipset 1632 are coupled to storage device 1650, for example, via an interface (I/F) 1638. The I/F 1638 may be, for example, a Peripheral Component Interconnect-enhanced (PCIe) interface, a Compute Express Link ^{®} (CXL) interface, or a Universal Chiplet Interconnect Express (UCIe) interface. Storage device 1650 stores instructions executable by circuitry of computing architecture 1600 (e.g., processor 1604, processor 1606, GPU 1648, accelerator 1654, vision processing unit 1656, or the like). For example, storage device 1650 can store instructions for the client device 1202, the client device 1206, the inferencing device 1204, the training device 1314, or the like.

Processor 1604 couples to the chipset 1632 via P2P interface 1628 and P2P 1634 while processor 1606 couples to the chipset 1632 via P2P interface 1630 and P2P 1636. Direct media interface (DMI) 1676 and DMI 1678 couple the P2P interface 1628 and the P2P 1634 and the P2P interface 1630 and P2P 1636, respectively. DMI 1676 and DMI 1678 is a high-speed interconnect that facilitates, e.g., eight Giga Transfers per second (GT/s) such as DMI 3.0. In other embodiments, the processor 1604 and processor 1606 interconnect via a bus.

The chipset 1632 comprises a controller hub such as a platform controller hub (PCH). The chipset 1632 includes a system clock to perform clocking functions and include interfaces for an I/O bus such as a universal serial bus (USB), peripheral component interconnects (PCIs), CXL interconnects, UCIe interconnects, interface serial peripheral interconnects (SPIs), integrated interconnects (I2Cs), and the like, to facilitate connection of peripheral devices on the platform. In other embodiments, the chipset 1632 comprises more than one controller hub such as a chipset with a memory controller hub, a graphics controller hub, and an input/output (I/O) controller hub.

In the depicted example, chipset 1632 couples with a trusted platform module (TPM) 1644 and UEFI, BIOS, FLASH circuitry 1646 via I/F 1642. The TPM 1644 is a dedicated microcontroller designed to secure hardware by integrating cryptographic keys into devices. The UEFI, BIOS, FLASH circuitry 1646 may provide pre-boot code. The I/F 1642 may also be coupled to a network interface circuit (NIC) 1680 for connections off-chip.

Furthermore, chipset 1632 includes the I/F 1638 to couple chipset 1632 with a high-performance graphics engine, such as, graphics processing circuitry or a graphics processing unit (GPU) 1648. In other embodiments, the computing architecture 1600 includes a flexible display interface (FDI) (not shown) between the processor 1604 and/or the processor 1606 and the chipset 1632. The FDI interconnects a graphics processor core in one or more of processor 1604 and/or processor 1606 with the chipset 1632.

The computing architecture 1600 is operable to communicate with wired and wireless devices or entities via the network interface (NIC) 180 using the IEEE 802 family of standards, such as wireless devices operatively disposed in wireless communication (e.g., IEEE 802.11 over-the-air modulation techniques). This includes at least Wi-Fi (or Wireless Fidelity), WiMax, and Bluetooth^{™} wireless technologies, 3G, 4G, LTE wireless technologies, among others. Thus, the communication is a predefined structure as with a conventional network or simply an ad hoc communication between at least two devices. Wi-Fi networks use radio technologies called IEEE 802.11x (a, b, g, n, ac, ax, etc.) to provide secure, reliable, fast wireless connectivity. A Wi-Fi network is used to connect computers to each other, to the Internet, and to wired networks (which use IEEE 802.3-related media and functions).

Additionally, accelerator 1654 and/or vision processing unit 1656 are coupled to chipset 1632 via I/F 1638. The accelerator 1654 is representative of any type of accelerator device (e.g., a data streaming accelerator, cryptographic accelerator, cryptographic coprocessor, an offload engine, etc.). One example of an accelerator 1654 is the Intel^{®} Data Streaming Accelerator (DSA). The accelerator 1654 is a device including circuitry to accelerate copy operations, data encryption, hash value computation, data comparison operations (including comparison of data in memory 1616 and/or memory 1618), and/or data compression. Examples for the accelerator 1654 include a USB device, PCI device, PCIe device, CXL device, UCIe device, and/or an SPI device. The accelerator 1654 also includes circuitry arranged to execute machine learning (ML) related operations (e.g., training, inference, etc.) for ML models. Generally, the accelerator 1654 is specially designed to perform computationally intensive operations, such as hash value computations, comparison operations, cryptographic operations, and/or compression operations, in a manner that is more efficient than when performed by the processor 1604 or processor 1606. Because the load of the computing architecture 1600 includes hash value computations, comparison operations, cryptographic operations, and/or compression operations, the accelerator 1654 greatly increases performance of the computing architecture 1600 for these operations.

The accelerator 1654 includes one or more dedicated work queues and one or more shared work queues (each not pictured). Generally, a shared work queue is configured to store descriptors submitted by multiple software entities. The software is any type of executable code, such as a process, a thread, an application, a virtual machine, a container, a microservice, etc., that share the accelerator 1654. For example, the accelerator 1654 is shared according to the Single Root I/O virtualization (SR-IOV) architecture and/or the Scalable I/O virtualization (S-IOV) architecture. Embodiments are not limited in these contexts. In some embodiments, software uses an instruction to atomically submit the descriptor to the accelerator 1654 via a non-posted write (e.g., a deferred memory write (DMWr)). One example of an instruction that atomically submits a work descriptor to the shared work queue of the accelerator 1654 is the ENQCMD command or instruction (which may be referred to as "ENQCMD" herein) supported by the Intel^{®} Instruction Set Architecture (ISA). However, any instruction having a descriptor that includes indications of the operation to be performed, a source virtual address for the descriptor, a destination virtual address for a device-specific register of the shared work queue, virtual addresses of parameters, a virtual address of a completion record, and an identifier of an address space of the submitting process is representative of an instruction that atomically submits a work descriptor to the shared work queue of the accelerator 1654. The dedicated work queue may accept job submissions via commands such as the movdir64b instruction.

Various I/O devices 1660 and display 1652 couple to the bus 1672, along with a bus bridge 1658 which couples the bus 1672 to a second bus 1674 and an I/F 1640 that connects the bus 1672 with the chipset 1632. In one embodiment, the second bus 1674 is a low pin count (LPC) bus. Various input/output (I/O) devices couple to the second bus 1674 including, for example, a keyboard 1662, a mouse 1664 and communication devices 1666.

Furthermore, an audio I/O 1668 couples to second bus 1674. Many of the I/O devices 1660 and communication devices 1666 reside on the system-on-chip (SoC) 1602 while the keyboard 1662 and the mouse 1664 are add-on peripherals. In other embodiments, some or all the I/O devices 1660 and communication devices 1666 are add-on peripherals and do not reside on the system-on-chip (SoC) 1602.

FIG. 17 illustrates a block diagram of an exemplary communications architecture 1700 suitable for implementing various embodiments as previously described. The communications architecture 1700 includes various common communications elements, such as a transmitter, receiver, transceiver, radio, network interface, baseband processor, antenna, amplifiers, filters, power supplies, and so forth. The embodiments, however, are not limited to implementation by the communications architecture 1700.

As shown in FIG. 17, the communications architecture 1700 includes one or more clients 1702 and servers 1704. The clients 1702 and the servers 1704 are operatively connected to one or more respective client data stores 1708 and server data stores 1710 that can be employed to store information local to the respective clients 1702 and servers 1704, such as cookies and/or associated contextual information.

The clients 1702 and the servers 1704 communicate information between each other using a communication framework 1706. The communication framework 1706 implements any well-known communications techniques and protocols. The communication framework 1706 is implemented as a packet-switched network (e.g., public networks such as the Internet, private networks such as an enterprise intranet, and so forth), a circuit-switched network (e.g., the public switched telephone network), or a combination of a packet-switched network and a circuit-switched network (with suitable gateways and translators).

The communication framework 1706 implements various network interfaces arranged to accept, communicate, and connect to a communications network. A network interface is regarded as a specialized form of an input output interface. Network interfaces employ connection protocols including without limitation direct connect, Ethernet (e.g., thick, thin, twisted pair 10/1200/1000 Base T, and the like), token ring, wireless network interfaces, cellular network interfaces, IEEE 802.11 network interfaces, IEEE 802.16 network interfaces, IEEE 802.20 network interfaces, and the like. Further, multiple network interfaces are used to engage with various communications network types. For example, multiple network interfaces are employed to allow for the communication over broadcast, multicast, and unicast networks. Should processing requirements dictate a greater amount speed and capacity, distributed network controller architectures are similarly employed to pool, load balance, and otherwise increase the communicative bandwidth required by clients 1702 and the servers 1704. A communications network is any one and the combination of wired and/or wireless networks including without limitation a direct interconnection, a secured custom connection, a private network (e.g., an enterprise intranet), a public network (e.g., the Internet), a Personal Area Network (PAN), a Local Area Network (LAN), a Metropolitan Area Network (MAN), an Operating Missions as Nodes on the Internet (OMNI), a Wide Area Network (WAN), a wireless network, a cellular network, and other communications networks.

Any of the above embodiments may be implemented as instructions stored on a non-transitory computer-readable storage medium and/or embodied as an apparatus with a memory and a circuitry configured to perform the actions described above. It is contemplated that these embodiments may be deployed individually to achieve improvements in resource requirements and library construction time. Alternatively, any of the embodiments may be used in combination with each other in order to achieve synergistic effects, some of which are noted above and elsewhere herein.

The various elements of the devices as previously described with reference to the figures include various hardware elements, software elements, or a combination of both. Examples of hardware elements include devices, logic devices, components, processors, microprocessors, circuits, processors, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), memory units, logic gates, registers, semiconductor device, chips, microchips, chip sets, and so forth. Examples of software elements include software components, programs, applications, computer programs, application programs, system programs, software development programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. However, determining whether an embodiment is implemented using hardware elements and/or software elements varies in accordance with any number of factors, such as desired computational rate, power levels, heat tolerances, processing cycle budget, input data rates, output data rates, memory resources, data bus speeds and other design or performance constraints, as desired for a given implementation.

One or more aspects of at least one embodiment are implemented by representative instructions stored on a machine-readable medium which represents various logic within the processor, which when read by a machine causes the machine to fabricate logic to perform the techniques described herein. Such representations, known as "intellectual property (IP) cores" are stored on a tangible, machine readable medium and supplied to various customers or manufacturing facilities to load into the fabrication machines that make the logic or processor. Some embodiments are implemented, for example, using a machine-readable medium or article which may store an instruction or a set of instructions that, when executed by a machine, causes the machine to perform a method and/or operations in accordance with the embodiments. Such a machine includes, for example, any suitable processing platform, computing platform, computing device, processing device, computing system, processing system, processing devices, computer, processor, or the like, and is implemented using any suitable combination of hardware and/or software. The machine-readable medium or article includes, for example, any suitable type of memory unit, memory device, memory article, memory medium, storage device, storage article, storage medium and/or storage unit, for example, memory, removable or non-removable media, erasable or non-erasable media, writeable or re-writeable media, digital or analog media, hard disk, floppy disk, Compact Disk Read Only Memory (CD-ROM), Compact Disk Recordable (CD-R), Compact Disk Rewriteable (CD-RW), optical disk, magnetic media, magneto-optical media, removable memory cards or disks, various types of Digital Versatile Disk (DVD), a tape, a cassette, or the like. The instructions include any suitable type of code, such as source code, compiled code, interpreted code, executable code, static code, dynamic code, encrypted code, and the like, implemented using any suitable high-level, low-level, object-oriented, visual, compiled and/or interpreted programming language.

As utilized herein, terms "component," "system," "interface," and the like are intended to refer to a computer-related entity, hardware, software (e.g., in execution), and/or firmware. For example, a component is a processor (e.g., a microprocessor, a controller, or other processing device), a process running on a processor, a controller, an object, an executable, a program, a storage device, a computer, a tablet PC and/or a user equipment (e.g., mobile phone, etc.) with a processing device. By way of illustration, an application running on a server and the server is also a component. One or more components reside within a process, and a component is localized on one computer and/or distributed between two or more computers. A set of elements or a set of other components are described herein, in which the term "set" can be interpreted as "one or more."

Further, these components execute from various computer readable storage media having various data structures stored thereon such as with a module, for example. The components communicate via local and/or remote processes such as in accordance with a signal having one or more data packets (e.g., data from one component interacting with another component in a local system, distributed system, and/or across a network, such as, the Internet, a local area network, a wide area network, or similar network with other systems via the signal).

As another example, a component is an apparatus with specific functionality provided by mechanical parts operated by electric or electronic circuitry, in which the electric or electronic circuitry is operated by a software application or a firmware application executed by one or more processors. The one or more processors are internal or external to the apparatus and execute at least a part of the software or firmware application. As yet another example, a component is an apparatus that provides specific functionality through electronic components without mechanical parts; the electronic components include one or more processors therein to execute software and/or firmware that confer(s), at least in part, the functionality of the electronic components.

Use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more" unless specified otherwise or clear from context to be directed to a singular form. Furthermore, to the extent that the terms "including", "includes", "having", "has", "with", or variants thereof are used in either the detailed description or the claims, such terms are intended to be inclusive in a manner similar to the term "comprising." Additionally, in situations wherein one or more numbered items are discussed (e.g., a "first X", a "second X", etc.), in general the one or more numbered items may be distinct or they may be the same, although in some situations the context may indicate that they are distinct or that they are the same.

As used herein, the term "circuitry" may refer to, be part of, or include a circuit, an integrated circuit (IC), a monolithic IC, a discrete circuit, a hybrid integrated circuit (HIC), an Application Specific Integrated Circuit (ASIC), an electronic circuit, a logic circuit, a microcircuit, a hybrid circuit, a microchip, a chip, a chiplet, a chipset, a multi-chip module (MCM), a semiconductor die, a system on a chip (SoC), a processor (shared, dedicated, or group), a processor circuit, a processing circuit, or associated memory (shared, dedicated, or group) operably coupled to the circuitry that execute one or more software or firmware programs, a combinational logic circuit, or other suitable hardware components that provide the described functionality. In some embodiments, the circuitry is implemented in, or functions associated with the circuitry are implemented by, one or more software or firmware modules. In some embodiments, circuitry includes logic, at least partially operable in hardware. It is noted that hardware, firmware and/or software elements may be collectively or individually referred to herein as "logic" or "circuit."

Some embodiments are described using the expression "one embodiment" or "an embodiment" along with their derivatives. These terms mean that a particular feature, structure, or characteristic described in connection with the embodiment is included in at least one embodiment. The appearances of the phrase "in one embodiment" in various places in the specification are not necessarily all referring to the same embodiment. Moreover, unless otherwise noted the features described above are recognized to be usable together in any combination. Thus, any features discussed separately can be employed in combination with each other unless it is noted that the features are incompatible with each other.

Some embodiments are presented in terms of program procedures executed on a computer or network of computers. A procedure is here, and generally, conceived to be a selfconsistent sequence of operations leading to a desired result. These operations are those requiring physical manipulations of physical quantities. Usually, though not necessarily, these quantities take the form of electrical, magnetic or optical signals capable of being stored, transferred, combined, compared, and otherwise manipulated. It proves convenient at times, principally for reasons of common usage, to refer to these signals as bits, values, elements, symbols, characters, terms, numbers, or the like. It should be noted, however, that all of these and similar terms are to be associated with the appropriate physical quantities and are merely convenient labels applied to those quantities.

Further, the manipulations performed are often referred to in terms, such as adding or comparing, which are commonly associated with mental operations performed by a human operator. No such capability of a human operator is necessary, or desirable in most cases, in any of the operations described herein, which form part of one or more embodiments. Rather, the operations are machine operations. Useful machines for performing operations of various embodiments include general purpose digital computers or similar devices.

Some embodiments are described using the expression "coupled" and "connected" along with their derivatives. These terms are not necessarily intended as synonyms for each other. For example, some embodiments are described using the terms "connected" and/or "coupled" to indicate that two or more elements are in direct physical or electrical contact with each other. The term "coupled", however, also means that two or more elements are not in direct contact with each other, but yet still co-operate or interact with each other.

Various embodiments also relate to apparatus or systems for performing these operations. This apparatus is specially constructed for the required purpose or it comprises a general purpose computer as selectively activated or reconfigured by a computer program stored in the computer. The procedures presented herein are not inherently related to a particular computer or other apparatus. Various general purpose machines are used with programs written in accordance with the teachings herein, or it proves convenient to construct more specialized apparatus to perform the required method steps. The required structure for a variety of these machines are apparent from the description given.

It is emphasized that the Abstract of the Disclosure is provided to allow a reader to quickly ascertain the nature of the technical disclosure. It is submitted with the understanding that it will not be used to interpret or limit the scope or meaning of the claims. In addition, the following claims are hereby incorporated into the Detailed Description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

The techniques described herein may be implemented with privacy safeguards to protect user privacy. Furthermore, the techniques described herein may be implemented with user privacy safeguards to prevent unauthorized access to personal data and confidential data. The training of the AI models described herein is executed to benefit all users fairly, without causing or amplifying unfair bias.

According to some embodiments, the techniques for the models described herein do not make inferences or predictions about individuals unless requested to do so through an input. According to some embodiments, the models described herein do not learn from and are not trained on user data without user authorization. In instances where user data is permitted and authorized for use in AI features and tools, it is done in compliance with a user's visibility settings, privacy choices, user agreement and descriptions, and the applicable law. According to the techniques described herein, users may have full control over the visibility of their content and who sees their content, as is controlled via the visibility settings. According to the techniques described herein, users may have full control over the level of their personal data that is shared and distributed between different AI platforms that provide different functionalities. According to the techniques described herein, users may choose to share personal data with different platforms to provide services that are more tailored to the users. In instances where the users choose not to share personal data with the platforms, the choices made by the users will not have any impact on their ability to use the services that they had access to prior to making their choice.

According to the techniques described herein, users may have full control over the level of access to their personal data that is shared with other parties. According to the techniques described herein, personal data provided by users may be processed to determine prompts when using a generative AI feature at the request of the user, but not to train generative AI models. In some embodiments, users may provide feedback while using the techniques described herein, which may be used to improve or modify the platform and products. In some embodiments, any personal data associated with a user, such as personal information provided by the user to the platform, may be deleted from storage upon user request. In some embodiments, personal information associated with a user may be permanently deleted from storage when a user deletes their account from the platform.

According to the techniques described herein, personal data may be removed from any training dataset that is used to train AI models. The techniques described herein may utilize tools for anonymizing member and customer data. For example, user's personal data may be redacted and minimized in training datasets for training AI models through delexicalisation tools and other privacy enhancing tools for safeguarding user data. The techniques described herein may minimize use of any personal data in training AI models, including removing and replacing personal data. According to the techniques described herein, notices may be communicated to users to inform how their data is being used and users are provided controls to opt-out from their data being used for training AI models.

According to some embodiments, tools are used with the techniques described herein to identify and mitigate risks associated with AI in all products and AI systems. In some embodiments, notices may be provided to users when AI tools are being used to provide features.

The following examples pertain to further embodiments, from which numerous permutations and configurations will be apparent.

In one example, a method includes decoding sensor data from a sensor of an electronic component of an electronic device, generating a control directive to move a software defined cooling (SDC) structure of a cooling system from a first position to a second position based on the sensor data, moving the SDC structure from the first position to the second position in response to the control directive, the second position to comprise a position within a defined distance to the electronic component of the electronic device, and performing thermal management of the electronic component using the SDC structure.

The method may also include where the first position and the second position represent numerical coordinates in a three-dimensional (3D) coordinate system.

The method may also include where the first position is located in a first cooling zone and the second position is located in a second cooling zone.

The method may also include accessing configuration data for a cooling zone where the electronic component is located, the configuration data includes a volumetric area for the cooling zone, a service level objective (SLO) of a service level agreement (SLA) defining an operating target for the cooling zone, a priority level associated with the cooling zone, or reservation data for the cooling zone.

The method may also include decoding sensor data from a sensor that the SDC structure is located at the second position, and generating a control directive to initiate cooling operations of the SDC structure to reduce a temperature of the electronic component by the SDC structure.

In one example, a computing apparatus includes a memory. The computing apparatus also includes circuitry operably coupled to the memory, the circuitry to perform operations includes decode sensor data from a sensor of an electronic component of an electronic device, generate a control directive to move a software defined cooling (SDC) structure of a cooling system from a first position to a second position based on the sensor data, move the SDC structure from the first position to the second position in response to the control directive, the second position to comprise a position within a defined distance to the electronic component of the electronic device, and perform thermal management of the electronic component using the SDC structure.

The computing apparatus may also include where the first position and the second position represent numerical coordinates in a three-dimensional (3D) coordinate system.

The computing apparatus may also include where the first position is located in a first cooling zone and the second position is located in a second cooling zone.

The computing apparatus may also include the circuitry to perform operations includes access configuration data for a cooling zone where the electronic component is located, the configuration data includes a volumetric area for the cooling zone, a service level agreement (SLA) defining an operating target for the cooling zone, a priority level associated with the cooling zone, or reservation data for the cooling zone.

The computing apparatus may also include the circuitry to perform operations includes decode sensor data from a sensor that the SDC structure is located at the second position, and generate a control directive to initiate cooling operations of the SDC structure to reduce a temperature of the electronic component by the SDC structure.

In one example, a non-transitory computer-readable medium storing executable instructions, which when executed by circuitry, cause the circuitry to perform operations includes decode sensor data from a sensor of an electronic component of an electronic device, generate a control directive to move a software defined cooling (SDC) structure of a cooling system from a first position to a second position based on the sensor data, move the SDC structure from the first position to the second position in response to the control directive, the second position to comprise a position within a defined distance to the electronic component of the electronic device, and perform thermal management of the electronic component using the SDC structure.

The computer-readable storage medium may also include where the first position and the second position represent numerical coordinates in a three-dimensional (3D) coordinate system. The computer-readable storage medium may also include where the first position is located in a first cooling zone and the second position is located in a second cooling zone.

The computer-readable storage medium may also include executable instructions, which when executed by circuitry, cause the circuitry to perform operations includes access configuration data for a cooling zone where the electronic component is located, the configuration data includes a volumetric area for the cooling zone, a service level agreement (SLA) defining an operating target for the cooling zone, a priority level associated with the cooling zone, or reservation data for the cooling zone.

The computer-readable storage medium may also include executable instructions, which when executed by circuitry, cause the circuitry to perform operations includes decode sensor data from a sensor that the SDC structure is located at the second position, and generate a control directive to initiate cooling operations of the SDC structure to reduce a temperature of the electronic component by the SDC structure.

The method may also include generating the control directive to move the SDC structure of the cooling system from the first position to the second position based on the sensor data and the volumetric area for the cooling zone, the SLO of the SLA for the cooling zone, the priority level associated with the cooling zone, or the reservation data for the cooling zone.

The method may also include receiving as input the configuration data for the cooling zone by a machine learning model for a first defined time interval, and generating an amount of cooling the SDC structure delivers for the cooling zone within the first defined time interval by the machine learning model based on the configuration data.

The method may also include receiving as input the reservation data for the cooling zone by a machine learning model for a first defined time interval and a second defined time interval, generating an amount of cooling the SDC structure delivers for the cooling zone within the first defined time interval and the second defined time interval by the machine learning model based on the reservation data.

The computing apparatus may also include the circuitry to perform operations includes generate the control directive to move the SDC structure of the cooling system from the first position to the second position based on the sensor data and the volumetric area for the cooling zone, the SLA for the cooling zone, the priority level associated with the cooling zone, or the reservation data for the cooling zone.

The computing apparatus may also include the circuitry to perform operations includes receive as input the configuration data for the cooling zone by a machine learning model for a first defined time interval, and generate an amount of cooling the SDC structure delivers for the cooling zone within the first defined time interval by the machine learning model based on the configuration data.

The computing apparatus may also include the circuitry to perform operations includes receive as input the reservation data for the cooling zone by a machine learning model for a first defined time interval and a second defined time interval, generate an amount of cooling the SDC structure delivers for the cooling zone within the first defined time interval and the second defined time interval by the machine learning model based on the reservation data.

The computer-readable storage medium may also include executable instructions, which when executed by circuitry, cause the circuitry to perform operations includes generate the control directive to move the SDC structure of the cooling system from the first position to the second position based on the sensor data and the volumetric area for the cooling zone, the SLA for the cooling zone, the priority level associated with the cooling zone, or the reservation data for the cooling zone.

The computer-readable storage medium may also include executable instructions, which when executed by circuitry, cause the circuitry to perform operations includes receive as input the configuration data for the cooling zone by a machine learning model for a first defined time interval, and generate an amount of cooling the SDC structure delivers for the cooling zone within the first defined time interval by the machine learning model based on the configuration data.

The computer-readable storage medium may also include executable instructions, which when executed by circuitry, cause the circuitry to perform operations includes receive as input the reservation data for the cooling zone by a machine learning model for a first defined time interval and a second defined time interval, generate an amount of cooling the SDC structure delivers for the cooling zone within the first defined time interval and the second defined time interval by the machine learning model based on the reservation data.

## Claims

1. A method comprising:
decoding sensor data from a sensor of an electronic component of an electronic device;
generating a control directive to move a software defined cooling (SDC) structure of a cooling system from a first position to a second position based on the sensor data;
moving the SDC structure from the first position to the second position in response to the control directive, the second position to comprise a position within a defined distance to the electronic component of the electronic device; and
performing thermal management of the electronic component using the SDC structure.

2. The method of claim 1, wherein the first position and the second position represent numerical coordinates in a three-dimensional (3D) coordinate system.

3. The method of any of claims 1 to 2, wherein the first position is located in a first cooling zone and the second position is located in a second cooling zone.

4. The method of any of claims 1 to 3, comprising accessing configuration data for a cooling zone where the electronic component is located, the configuration data comprising a volumetric area for the cooling zone, a service level objective (SLO) of a service level agreement (SLA) defining an operating target for the cooling zone, a priority level associated with the cooling zone, or reservation data for the cooling zone.

5. The method of claim 4, comprising generating the control directive to move the SDC structure of the cooling system from the first position to the second position based on the sensor data and the volumetric area for the cooling zone, the SLO of the SLA for the cooling zone, the priority level associated with the cooling zone, or the reservation data for the cooling zone.

6. The method of any of claims 1 to 5, comprising:
receiving as input the reservation data for the cooling zone by a machine learning model for a first defined time interval and a second defined time interval;
generating an amount of cooling the SDC structure delivers for the cooling zone within the first defined time interval and the second defined time interval by the machine learning model based on the reservation data.

7. The method of any of claims 1 to 6, comprising:
decoding sensor data from a sensor that the SDC structure is located at the second position; and
generating a control directive to initiate cooling operations of the SDC structure to reduce a temperature of the electronic component by the SDC structure.

8. A computing apparatus comprising:
a memory; and
circuitry operably coupled to the memory, the circuitry to perform operations comprising:
decode sensor data from a sensor of an electronic component of an electronic device;
generate a control directive to move a software defined cooling (SDC) structure of a cooling system from a first position to a second position based on the sensor data;
move the SDC structure from the first position to the second position in response to the control directive, the second position to comprise a position within a defined distance to the electronic component of the electronic device; and
perform thermal management of the electronic component using the SDC structure.

9. The computing apparatus of claim 8, wherein the first position and the second position represent numerical coordinates in a three-dimensional (3D) coordinate system.

10. The computing apparatus of any of claims 8 to 9, wherein the first position is located in a first cooling zone and the second position is located in a second cooling zone.

11. The computing apparatus of any of claims 8 to 10, the circuitry to perform operations comprising access configuration data for a cooling zone where the electronic component is located, the configuration data comprising a volumetric area for the cooling zone, a service level agreement (SLA) defining an operating target for the cooling zone, a priority level associated with the cooling zone, or reservation data for the cooling zone.

12. The computing apparatus of claim 11, the circuitry to perform operations comprising generate the control directive to move the SDC structure of the cooling system from the first position to the second position based on the sensor data and the volumetric area for the cooling zone, the SLA for the cooling zone, the priority level associated with the cooling zone, or the reservation data for the cooling zone.

13. The computing apparatus of any of claims 8 to 12, the circuitry to perform operations comprising:
receive as input the reservation data for the cooling zone by a machine learning model for a first defined time interval and a second defined time interval;
generate an amount of cooling the SDC structure delivers for the cooling zone within the first defined time interval and the second defined time interval by the machine learning model based on the reservation data.

14. An apparatus comprising means to perform a method as claimed in any preceding claim.

15. Machine-readable storage including machine-readable instructions, when executed, to implement a method or realize an apparatus as claimed in any preceding claim.
